(19) **Europäisches Patentamt / European Patent Office / Office européen des brevets**

(11) **EP 3 376 544 B1**

(12) **FASCICULE DE BREVET EUROPEEN**

(45) Date de publication et mention de la délivrance du brevet:
**01.05.2024 Bulletin 2024/18**

(21) Numéro de dépôt: **18161920.6**

(22) Date de dépôt: **15.03.2018**

(51) Classification Internationale des Brevets (IPC):
**H10K 59/65** *(2023.01)* **H01L 27/146** *(2006.01)*
**H05B 45/30** *(2020.01)*

(52) Classification Coopérative des Brevets (CPC):
**H01L 27/14609; H01L 27/14643; H01L 27/14678; H05B 45/30; H10K 59/65**

(54) **DISPOSITIF IMAGEUR OPTIQUE**

OPTISCHE BILDANZEIGEVORRICHTUNG

OPTICAL IMAGING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.03.2017 FR 1752160**

(43) Date de publication de la demande:
**19.09.2018 Bulletin 2018/38**

(73) Titulaires:
- **Commissariat à l'énergie atomique et aux énergies alternatives
75015 Paris (FR)**
- **Idemia Identity & Security France
92400 Courbevoie (FR)**

(72) Inventeurs:
- **MAINGUET, Jean-François
38100 GRENOBLE (FR)**
- **TEMPLIER, François
38054 GRENOBLE CEDEX 9 (FR)**

(74) Mandataire: **Brevalex
Tour Trinity
1 B Place de la Défense
92400 Courbevoie (FR)**

(56) Documents cités:
**US-A- 5 627 364        US-A1- 2002 079 512
US-A1- 2007 291 325     US-A1- 2010 155 578**

Processed by Luminess, 75001 PARIS (FR)

**Description**

**DOMAINE TECHNIQUE ET ART ANTÉRIEUR**

L'invention concerne le domaine des dispositifs imageurs optiques, et notamment celui des capteurs d'empreintes digitales, configurés pour réaliser une capture d'image par voie optique, c'est-à-dire en réalisant une détection de lumière.

Dans un capteur d'empreinte digitale réalisant une capture d'image par voie optique, il est connu d'utiliser une source lumineuse de type OLED (diode électroluminescente organique) réalisée sur un substrat transparent, et un photo-détecteur tel qu'une diode pour lire le signal. Etant donné la résolution requise pour un capteur, généralement d'au moins 500 ppp (pixels par pouce), il est difficile d'intégrer dans un même pixel le photo-détecteur (par exemple une diode PIN) et une source lumineuse (par exemple une diode électroluminescente organique) avec leur transistor de commande.

Il existe des capteurs d'empreinte digitale dans lesquels la capture d'une image d'empreinte digitale est réalisée dans une configuration dite « en champ proche », dans laquelle le doigt dont l'empreinte est imagée doit se trouver à faible distance (de l'ordre de la résolution recherchée, soit environ 50 $\mu$m pour un capteur de résolution égale à 500 ppp) des moyens de mesure du capteur. Le document US 2015/0331508 A1 décrit un dispositif pouvant former un tel capteur.

Cette nécessité d'avoir le doigt positionné à une très faible distance des moyens de mesure du capteur est toutefois un inconvénient important car il n'est pas possible dans ce cas d'interposer entre le capteur et le doigt dont l'empreinte est imagée un élément de protection, par exemple une plaque de verre, d'épaisseur suffisante pour assurer une bonne protection de l'électronique du capteur.

Pour éviter cette proximité du doigt et du capteur, il est possible d'interposer entre le capteur et le doigt des moyens optiques permettant de guider la lumière entre le doigt et le capteur, comme par exemple des fibres optiques ou des lentilles comme décrit dans le document US 6 259 108 B1. Cela est toutefois très contraignant, à la fois technologiquement et économiquement.

Le document US 2007/291325 A1 décrit un dispositif combinant une fonction imageur et une fonction afficheur.

Le document US 5 627 364 A décrit un dispositif imageur linéaire comprenant un substrat 30 sur lequel sont formés plusieurs éléments photodétecteurs et une source lumineuse formée linéairement le long des éléments photo-détecteurs.

Le document US 2002/079512 A1 décrit un dispositif imageur combinant une matrice de sources lumineuses formant un écran d'affichage et une matrice de photodétecteurs entrelacée avec la matrice de sources lumineuses.

Le document US 2010/155578 A1 décrit un dispositif imageur optique comprenant une matrice de photodétecteurs et des lignes de sources lumineuses.

**EXPOSÉ DE L'INVENTION**

Un but de la présente invention est de proposer un dispositif imageur configuré pour mettre en oeuvre une détection optique d'un élément à imager dans une configuration qui ne soit pas en champ proche, c'est-à-dire qui soit compatible avec la présence d'un élément de protection épais entre l'élément à imager et les éléments électroniques du dispositif imageur (photo-détecteurs et sources lumineuses), qui ne nécessite pas la présence de moyens de guidage optique entre l'élément à imager et les photo-détecteurs du dispositif imageur.

Pour cela, la présente invention propose un dispositif imageur optique comportant au moins :

- une matrice de sources lumineuses sensiblement ponctuelles, réalisée sur un substrat et formant un écran d'affichage,
- une matrice de photo-détecteurs réalisée sur le substrat et entrelacée avec la matrice de sources lumineuses,
- un milieu optique d'épaisseur supérieure au pas des photo-détecteurs de la matrice de photo-détecteurs, recouvrant les sources lumineuses et les photo-détecteurs, à travers lequel une lumière destinée à être émise par les sources lumineuses est apte à se propager, et formant une surface de capture contre laquelle un élément à imager est destiné à être disposé et une surface de détection sensiblement parallèle à la surface de capture et contre laquelle les matrices de sources lumineuses et de photo-détecteurs sont disposées,
- des moyens de commande et de lecture configurés pour allumer et éteindre successivement chacune d'une partie des sources lumineuses et, au cours de l'allumage de chacune de ladite partie des sources lumineuses, à lire au moins une partie des photo-détecteurs destinés à recevoir des rayons de lumière issus de la source lumineuse allumée et ayant subi au moins une réflexion contre la surface de capture en formant, avec la surface de capture, un angle d'incidence de valeur comprise entre, ou égale à, celle d'un premier angle limite de réfraction défini par l'indice optique du milieu optique et l'indice optique de l'atmosphère dans laquelle se trouve l'élément à imager, et celle d'un deuxième angle limite de réfraction défini par l'indice optique du milieu optique et un indice optique supplémentaire de valeur supérieure à celle de l'indice optique de l'atmosphère dans laquelle se trouve l'élément à imager et inférieure ou égale à celle de l'indice optique de l'élément à imager.

Le pas des photo-détecteurs correspond à la distance séparant les centres des portions photosensibles de deux photo-détecteurs voisins agencés sur une même ligne ou une même colonne de la matrice de photo-détecteurs. Ce pas est par exemple égal à environ 50 $\mu$m. Dans ce cas, le milieu optique peut avoir une épaisseur supérieure à 50 $\mu$m.

Lorsque la matrice de photo-détecteurs n'est pas réalisée avec un pas constant, par exemple lorsque la distance séparant les centres des portions photosensibles de deux photo-détecteurs voisins agencés sur une même ligne de la matrice est différente de la distance séparant les centres des portions photosensibles de deux photo-détecteurs voisins agencés sur une même colonne de la matrice, ou bien que la distance séparant les centres des portions photosensibles de deux photo-détecteurs voisins agencés sur une même ligne ou colonne de la matrice est différente d'une ligne ou d'une colonne à l'autre, ou bien encore que cette distance varie au sein d'une même ligne ou colonne de la matrice, le pas considéré pour définir l'épaisseur minimale du milieu optique est celui ayant la valeur la plus grande parmi les différents pas présents au sein de la matrice de photo-détecteurs.

Dans ce dispositif imageur, les sources lumineuses émettent de manière sensiblement isotrope des rayons de lumière à travers le milieu optique. Pour les rayons formant, avec la surface de capture, un angle d'incidence compris entre les premier et deuxième angles limites de réfraction tels que définis ci-dessus, une partie de ces rayons sont réfléchis par l'interface entre le milieu optique et le milieu extérieur au dispositif, c'est-à-dire au niveau de la surface de capture, lorsque le milieu extérieur atteint par ces rayons correspond à l'environnement extérieur, ou l'atmosphère (air), dans lequel se trouve l'élément à imager, et d'autres rayons traversent cette interface lorsque le milieu extérieur atteint par ces autres rayons correspond à l'élément à imager (phénomène de réflexion totale frustrée). Les rayons lumineux réfléchis comportant l'information à détecter par les photo-détecteurs correspondent à ceux délimités par les premier et deuxième angles limites de réfraction.

En allumant successivement, une par une, une partie des sources lumineuses de la matrice, on obtient des images partielles de l'élément à imager qui sont détectées par les photo-détecteurs se trouvant dans la région éclairée par ces rayons réfléchis. Une image finale souhaitée de l'élément à imager peut ainsi être construite à partir de ces images partielles.

Ce dispositif imageur utilise judicieusement un milieu optique épais qui sert à la fois à la propagation des rayons lumineux depuis les sources lumineuses jusqu'au photo-détecteurs (via une réflexion sur la surface de capture), et à la protection des éléments électroniques (notamment les sources lumineuses et les photo-détecteurs) du dispositif imageur.

De manière avantageuse, le milieu optique peut correspondre à une plaque de verre d'un écran d'affichage. Au moins une partie des sources lumineuses des pixels de cet écran peuvent former les sources lumineuses du dispositif imageur (toutes les sources lumineuses de l'écran ne sont pas nécessairement utilisées pour réaliser les différentes acquisitions d'image). Avec ce dispositif imageur, il n'est pas nécessaire de réaliser un amincissement de la plaque de verre à l'emplacement de la matrice de photo-détecteurs car le dispositif imageur fonctionne parfaitement avec, en tant que milieu optique, un verre correspondant à un verre de protection standard d'un écran. De plus, la présence de ce milieu optique épais n'engendre pas de perte de précision dans l'image capturée car ce milieu optique fait partie du dispositif imageur et ne perturbe pas son fonctionnement.

En outre, la résolution de l'image finale obtenue de l'élément à imager est supérieure à la résolution avec laquelle la matrice de photo-détecteurs est réalisée du fait qu'un grandissement optique est naturellement obtenu étant donné le trajet des rayons lumineux au sein du milieu optique (avec une réflexion contre la surface de capture), et cela sans avoir d'optique de grossissement dédiée présente dans le dispositif imageur. Par exemple, lorsque les sources lumineuses et les photo-détecteurs sont disposés dans un même plan, par exemple réalisés sur un même substrat, un grandissement optique égal à 2 est obtenu (par exemple, avec une matrice de photo-détecteurs de résolution égale à 500 ppp, l'image obtenue avec ce dispositif imageur est équivalente à une image qui aurait été capturée avec une résolution initiale égale à 1000 ppp). Une résolution d'image de l'ordre de 2000 ppp ou supérieure à 2000 ppp peut également être aisément obtenue.

La réflexion des rayons lumineux contre la surface de capture correspond à une réflexion totale. En outre, les chemins optiques des rayons lumineux sont assez courts. Ainsi, les photo-détecteurs reçoivent beaucoup de lumière, ce qui permet de réaliser les photo-détecteurs par exemple sous la forme de photodiodes ayant de petites dimensions et/ou d'utiliser des architectures de lecture de type 1T (chaque diode est commandée par un seul transistor) grâce au meilleur signal fourni par les photo-détecteurs. Ainsi, les photo-détecteurs nécessitent peu de place pour leur réalisation, ce qui laisse de la place pour la réalisation des sources lumineuses sur le même substrat que les photo-détecteurs.

Une source de lumineuse est sensiblement ponctuelle lorsque la taille de la zone d'acquisition d'un pixel est supérieure à au moins deux fois, voire au moins trois fois, et de préférence supérieure à dix fois, la taille de la surface émettrice de la source lumineuse.

Ce dispositif imageur est particulièrement adapté pour former un capteur d'empreinte digitale, l'élément à imager correspondant à de la peau. En outre, l'atmosphère dans laquelle se trouve l'élément à imager peut correspondre à de l'air.

Etant donné que les sources lumineuses sont sensiblement ponctuelles, la partie de l'élément à imager recevant les rayons lumineux formant un angle d'incidence, avec la surface de capture, compris entre les premier et deuxième angles limites de réfraction a une forme annulaire. Après la réflexion contre la surface de capture, ces rayons lumineux arrivent sur la surface de détection en éclairant une région de la matrice de photo-détecteurs également de forme annulaire mais de plus grandes dimensions que celles de la partie de l'élément à imager qui est éclairée.

Un tel dispositif imageur propose une architecture permettant l'obtention d'images de l'élément à imager de résolution supérieure ou égale à 500 ppp tout en étant compatible avec une réalisation en technologie CMOS ou OLED.

En outre, le contraste des images obtenues avec ce dispositif imageur est élevé et comparable à celui obtenu avec un capteur à prisme en réflexion totale dont l'encombrement est bien plus important que celui de ce capteur.

La matrice de sources lumineuses est entrelacée avec celle des photo-détecteurs, c'est-à-dire que les sources lumineuses sont disposées au sein de la matrice de photo-détecteurs, et inversement les photo-détecteurs sont disposés au sein de la matrice de sources lumineuses.

La valeur de l'indice optique de l'atmosphère dans laquelle se trouve l'élément à imager et celle de l'indice optique supplémentaire peuvent être prédéterminées, c'est-à-dire prédéfinies avant de réaliser une capture d'image.

Les moyens de commande et de lecture peuvent être configurés pour lire, au cours de l'allumage de chacune de ladite partie des sources lumineuses, les photo-détecteurs se trouvant dans une région de la surface de détection de forme annulaire délimitée par les rayons de lumière réfléchis formant, contre la surface de capture, les premier et deuxième angles limites de réfraction. Pour des raisons pratiques, les moyens de commande et de lecture peuvent être configurés pour commander, à l'allumage de chacune de ladite partie des sources lumineuses, l'acquisition desdits rayons par les photo-détecteurs se trouvant dans une région de la surface de détection de forme carrée ou rectangulaire incluant la région de la surface de détection de forme annulaire. Ainsi, le temps de lecture, ou d'acquisition, des photo-détecteurs se trouvant dans une telle région de forme carrée ou rectangulaire est réduit et le traitement numérique ultérieur des images carrées ou rectangulaires obtenues avec une telle acquisition est alors facilité.

Les moyens de commande et de lecture peuvent être configurés tels que les photo-détecteurs lus au cours de l'allumage de chacune de la partie des sources lumineuses délivrent une image partielle de l'élément à imager telle que chacune des images partielles obtenues se recouvre partiellement avec au moins une autre des images partielles de l'élément à imager.

Dans ce cas, le dispositif imageur peut comporter en outre des moyens de calcul d'une image finale de l'élément à imager à partir des images partielles de l'élément à imager.

Le dispositif imageur peut comporter en outre des sources lumineuses supplémentaires disposées hors de la matrice de sources lumineuses et sensiblement alignées avec des bissectrices des angles formés par les coins de la matrice de sources lumineuses. De telles sources lumineuses supplémentaires peuvent notamment servir à réaliser l'acquisition des coins de la surface de capture qui ne peuvent pas être capturés en utilisant les sources lumineuses de la matrice.

Dans un premier mode de réalisation, le dispositif imageur peut être avantageusement réalisé sous la forme d'une puce électronique CMOS, c'est-à-dire comprenant des transistors réalisés en technologie CMOS sur un substrat de semi-conducteur tel que du silicium. Les sources lumineuses peuvent dans ce cas correspondre à des LEDs, avantageusement réalisées à partir de GaN formé au préalable sur le semi-conducteur du substrat.

Dans un deuxième mode de réalisation, le dispositif imageur peut comporter des transistors TFT réalisés par exemple sur un substrat transparent, par exemple en verre, et des sources lumineuses de type OLED.

Chaque pixel de l'écran d'affichage peut comporter une des sources lumineuses et un des photo-détecteurs. En variante, il est toutefois possible que certains pixels formés par la matrice de photo-détecteurs et la matrice de sources lumineuses ne comportent pas de source lumineuse (et donc uniquement un photo-détecteur). Il est également possible que certains pixels de l'écran d'affichage ne comportent pas de photo-détecteurs.

Les sources lumineuses peuvent être formées par des LEDs et les moyens de commande et de lecture peuvent comporter des transistors CMOS, ou les sources lumineuses peuvent être de type OLED et les moyens de commande et de lecture peuvent comporter des transistors TFT disposés de manière entrelacée avec la matrice de photo-détecteurs. La réalisation du dispositif imageur avec la technologie LED + transistors CMOS permet d'atteindre des résolutions très importantes. La réalisation du dispositif imageur avec la technologie OLED + TFT permet, grâce au grandissement optique obtenu, la réalisation de pixels du dispositif imageur avec des dimensions importantes à un coût réduit, par exemple réalisés avec un pas égal à environ 100 microns, et/ou d'augmenter la résolution de l'image en gardant des pixels de dimensions réduites.

De manière avantageuse, lorsque les sources lumineuses sont de type OLED et que les moyens de commande et de lecture comportent des transistors TFT, lesdits transistors TFT peuvent être réalisés sur le substrat qui est transparent et qui forme le milieu optique.

L'épaisseur du milieu optique peut être supérieure à environ 50 $\mu$m, ou le milieu optique peut comporter une plaque de verre d'épaisseur supérieure à environ 100 $\mu$m, ou supérieure ou égale à environ 200 $\mu$m, ou supérieure ou égale à environ 400 $\mu$m, ou supérieure ou égale à environ 700 $\mu$m.

Les moyens de commande et de lecture peuvent être configurés tels que les sources lumineuses allumées successivement forment des images partielles de l'élément à imager, c'est-à-dire ayant des dimensions inférieures aux dimensions totales de l'image finale, se recouvrant chacune partiellement avec au moins une autre des images partielles de l'élément à imager, l'image finale étant ensuite construite ultérieurement à partir de ces différentes images partielles. Dans une telle configuration, l'impact d'un ou plusieurs photo-détecteurs défaillants est donc réduit puisque le recouvrement des images partielles permet d'obtenir, sur plusieurs des images partielles, de l'information redondante de l'élément à imager.

L'invention porte également sur un procédé de capture d'images mis en oeuvre avec un dispositif imageur comportant au moins :

- une matrice de sources lumineuses sensiblement ponctuelles, réalisée sur un substrat et formant un écran d'affichage,
- une matrice de photo-détecteurs réalisée sur le substrat et entrelacée avec la matrice de sources lumineuses,
- un milieu optique d'épaisseur supérieure au pas des photo-détecteurs de la matrice de photo-détecteurs, recouvrant les sources lumineuses et les photo-détecteurs, à travers lequel une lumière destinée à être émise par les sources lumineuses est apte à se propager, et formant une surface de capture contre laquelle un élément à imager est destiné à être disposé et une surface de détection sensiblement parallèle à la surface de capture et contre laquelle les matrices de sources lumineuses et de photo-détecteurs sont disposées,

le procédé de capture d'images comportant la mise en oeuvre des étapes suivantes :

a) allumage d'une des sources lumineuses,
b) lecture d'au moins une partie des photo-détecteurs recevant des rayons de lumière issus de la source lumineuse allumée et ayant subi une réflexion contre la surface de capture en formant, avec la surface de capture, un angle d'incidence de valeur comprise entre, ou égale à, celle d'un premier angle limite de réfraction défini par l'indice optique du milieu optique et l'indice optique de l'atmosphère dans laquelle se trouve l'élément à imager, et celle d'un deuxième angle limite de réfraction défini par l'indice optique du milieu optique et un indice optique supplémentaire de valeur supérieure à celle de l'indice optique de l'atmosphère dans laquelle se trouve l'élément à imager et inférieure ou égale à celle de l'indice optique de l'élément à imager,
c) extinction de la source lumineuse allumée,

les étapes a) à c) étant répétées pour chacune d'une partie des sources lumineuses (104).

Les photo-détecteurs lus au cours de l'étape b) peuvent être ceux se trouvant dans une région de la surface de détection de forme annulaire délimitée par les rayons de lumière réfléchis formant, contre la surface de capture, les premier et deuxième angles limites de réfraction.

Les photo-détecteurs lus au cours de chaque mise en oeuvre de l'étape b) peuvent délivrer une image partielle de l'élément à imager telle que chacune des images partielles obtenues se recouvre partiellement avec au moins une autre des images partielles de l'élément à imager.

Le procédé peut comporter en outre la mise en oeuvre d'une étape de calcul d'une image finale de l'élément à imager à partir des images partielles de l'élément à imager.

Les étapes a) à c) peuvent également être mises en oeuvre pour des sources lumineuses supplémentaires disposées hors de la matrice de sources lumineuses et alignées avec des bissectrices des angles formés par les coins de la matrice de sources lumineuses.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente une vue de dessus schématique d'une partie d'un dispositif imageur, objet de la présente invention, selon un premier mode de réalisation,
- la figure 2 représente le phénomène de réflexion totale frustrée se produisant au sein du dispositif imageur, objet de la présente invention,
- la figure 3 représente le phénomène de réflexion totale frustrée se produisant au sein du dispositif imageur, objet de la présente invention, selon une variante de réalisation,

- la figure 4 représente schématiquement des régions de détection et de capture pouvant être obtenues avec un dispositif imageur, objet de la présente invention,
- les figures 5 à 8 représentent schématiquement différentes phases de capture mises en oeuvre lors d'une acquisition d'image par le dispositif imageur, objet de la présente invention,
- la figure 9 représente une vue de dessus schématique d'une partie d'un autre dispositif imageur,
- la figure 10 représente une vue en coupe schématique d'un dispositif imageur, objet de la présente invention, selon un deuxième mode de réalisation,
- la figure 11 représente un exemple de réalisation d'un empilement comportant des sources lumineuses de type OLED et des photo-détecteurs de type diode PIN d'un dispositif imageur, objet de la présente invention,
- la figure 12 représente une vue de dessus d'un exemple de réalisation d'un dispositif imageur, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

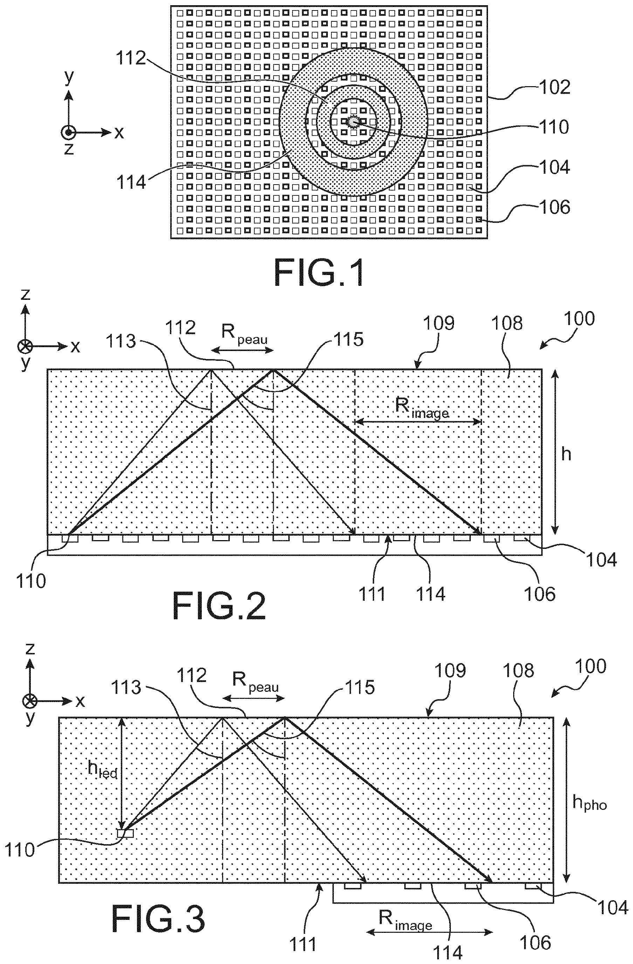

On se réfère tout d'abord à la figure 1 qui représente une vue de dessus d'une partie d'un dispositif imageur 100 selon un premier mode de réalisation.

Dans ce premier mode de réalisation, le dispositif 100 comporte, sur un même substrat 102 de semi-conducteur comprenant par exemple du silicium et du nitrure de gallium (GaN), une pluralité de sources lumineuses 104 sensiblement ponctuelles, correspondant ici à une matrice de LEDs, et une matrice de photo-détecteurs 106, ici des photodiodes. Les matrices de sources lumineuses 104 et de photo-détecteurs 106 sont ici entrelacées, c'est-à-dire que les sources lumineuses 104 sont disposées au sein de la matrice de photo-détecteurs 106, et les photo-détecteurs 106 sont également disposés au sein de la matrice de sources lumineuses 104. Dans ce premier mode de réalisation, le dispositif 100 comporte plusieurs pixels, formant par exemple une matrice de 88 x 88 pixels, comportant chacun une des sources lumineuses 104 et un des photo-détecteurs 106.

Les photo-détecteurs 106 correspondent par exemple à des diodes PN ou PIN, ou à des phototransistors réalisés dans le silicium du substrat 102. Les LEDs 104 sont avantageusement réalisées à partir du GaN reporté sur le silicium du substrat 102, ce GaN étant gravé de manière à former les sources lumineuses 104 sensiblement ponctuelles. En variante, les photo-détecteurs 106 peuvent être réalisés sur le substrat 102 après les sources lumineuses 104.

En outre, le substrat 102 sur lequel sont réalisées les matrices de LEDs 104 et de photodiodes 106 est recouvert d'un milieu optique 108 (visible sur la figure 2) qui correspond par exemple à une plaque de verre d'épaisseur supérieure à environ 100 μm, par exemple de l'ordre de 400 μm ou 700 μm ou encore 1000 μm, et ici collée au substrat 102.

En variante, le milieu optique 108 peut comporter du PMMA (dont l'indice optique est égal à environ 1,49), ou tout autre matériau transparent adapté.

Un adhésif, possédant avantageusement le même indice optique que celui du milieu optique 108 (ou très proche de celui-ci), peut être présent entre le milieu optique 108 et le substrat 102 qui comporte les LEDs 104 et les photodiodes 106. Il est également possible que le milieu optique 108 soit moulé directement sur le substrat 102. De manière générale, le milieu optique 108 est couplé optiquement au substrat 102 tel qu'il n'y ait pas d'air entre le milieu optique 108 et les photodiodes 106 ainsi qu'entre le milieu optique 108 et les LEDs 104.

Le dispositif imageur 100 est destiné à être couplé à un dispositif électronique à affichage, par exemple un smartphone ou une tablette informatique. Ainsi, la matrice de LEDs 104 et de photodiodes 106 forment un dispositif additionnel destiné à être disposé à côté de l'écran d'affichage de ce dispositif, le milieu optique 108 correspondant au verre de protection de cet écran.

Bien que non visible sur la figure 1, le dispositif imageur 100 comporte également des moyens de commande et de lecture configurés pour commander l'émission lumineuse réalisée par chacune des LEDs 104 et à commander la détection de l'information lumineuse reçue par les photodiodes 106. Ces moyens de commande et de lecture comportent des composants électroniques réalisés par exemple sur le substrat 102.

Lors d'une capture d'image par le dispositif imageur 100, par exemple lors d'une capture d'empreinte digitale d'un doigt posé sur le milieu optique 108, plusieurs LEDs 104 sont allumées successivement, une seule LED 104 étant allumée à la fois. Sur la figure 1, une des LEDs 104 est allumée et est désignée par la référence 110. Cette LED 110 éclaire la peau se trouvant au-dessus du milieu optique 108, sur une surface supérieure du milieu optique 108 appelée surface de capture 109 (visible sur la figure 2). Une région 112 de forme annulaire et formée autour de la LED 110 qui correspond au centre de cette région 112, correspond à la région où la lumière émise par la LED 110 subit une réflexion totale ou non suivant que de la peau soit en contact ou non avec la surface de capture 109. La région 112 est de forme annulaire car la LED 110 correspond à une source lumineuse sensiblement ponctuelle éclairant le milieu optique 108 de manière isotrope.

Avant d'atteindre la région 112, les rayons de lumière émis par la LED 110 traversent le milieu optique 108 depuis sa face arrière, appelée surface de détection 111, et qui recouvre les LEDs 104 et les photodiodes 106, jusqu'à atteindre sa face avant formant la surface de capture 109. Après avoir atteint la surface de capture 109, une partie de ces rayons (ceux qui ne rencontrent pas de peau présente au-dessus du milieu optique 108) se réfléchissent contre cette surface et traversent de nouveau le milieu optique 108 pour venir éclairer une partie des photodiodes 106 sur la surface de détection 111. Sur l'exemple de la figure 1, les rayons de lumière réfléchis qui formeront l'image destinée à être détectée par ces photodiodes 106 sont inclus, sur la surface de détection 111, dans la région 114 qui est également de forme annulaire et de dimensions plus importantes que celles de la région 112.

La figure 2 représente schématiquement ce qui est obtenu d'un point de vue optique au sein du dispositif imageur 100 lorsque la LED 110 est allumée.

Les caractéristiques optiques de la réflexion totale frustrée se produisant au niveau de la surface de capture 109 du milieu optique 108 dépend des indices optiques, ou indices de réfraction, des deux milieux formant l'interface considérée, c'est-à-dire ici le milieu optique 108 et l'environnement extérieur.

Lors du fonctionnement du dispositif imageur 100, la valeur de l'indice optique de l'environnement extérieur peut être considérée comme étant égale à une valeur fixe, par exemple égale à 1.

Lorsque le milieu optique 108 correspond à du verre, son indice optique $n_{108}$ est égal à environ 1,51.

Ensuite, étant donné que le dispositif imageur 100 est, dans ce premier mode de réalisation, destiné à réaliser une capture d'empreinte digitale, il convient de considérer l'indice optique de la peau, appelé $n_{peau}$, lorsque de la peau est en contact avec la surface de capture 109 (au niveau d'une crête de l'empreinte), et celui de l'air appelé $n_{air}$ (au niveau d'une vallée, ou creux, de l'empreinte, ou à côté de la peau). On considère ici de l'air (de valeur égale à 1) mais de manière générale, il convient de prendre en compte l'indice de l'atmosphère dans laquelle se trouve l'élément à imager.

La valeur de l'angle critique C, également appelé angle limite de réfraction, qui est celui correspondant à une réfraction de 90° tel que $C = \arcsin(n_1/n_2)$, avec $n_1 < n_2$ en considérant une interface entre deux milieux optiques d'indice $n_1$ et $n_2$, sera différente suivant que le rayon lumineux traverse le milieu optique 108 et arrive sur une partie de la surface de capture 109 en contact avec de la peau ou en contact avec de l'air.

La valeur de $n_{air}$ étant égale à 1 et celle de $n_{108}$ étant égale à 1,51, un premier angle limite de réfraction obtenu entre de l'air et du verre est donc $C_{air/verre} = \arcsin(1/1,51) = 41°$.

La valeur de $n_{peau}$ étant comprise entre 1,37 et 1,4 et celle de $n_{108}$ étant égale à 1,51, un deuxième angle limite de réfraction obtenu entre de la peau et du verre $C_{peau/verre}$ est donc compris entre les valeurs $\arcsin(1,4/1,51) = 68°$ et $\arcsin(1,37/1,51) = 65°$. Pour des raisons de simplification, seule la valeur de 65° sera considérée pour la suite.

De manière générale, la valeur du deuxième angle limite de réfraction peut être calculée en considérant l'indice optique $n_{108}$ du milieu optique 108, par exemple égal à 1,51 lorsque le milieu optique 108 correspond à du verre, et un indice optique supplémentaire de valeur supérieure à celle de l'indice optique de l'atmosphère dans laquelle se trouve l'élément à imager et inférieure ou égale à celle de l'indice optique $n_{peau}$ de l'élément à imager.

Ainsi, en reprenant la figure 2, lorsque les rayons de lumière émis par la source lumineuse allumée 110 forment un angle d'incidence, avec la normale à la surface de capture 109, compris entre 0 et 41°, aucune ou très peu de réflexion lumineuse se produit à l'interface formée au niveau de la surface 109. Les rayons de lumière sortent alors du milieu optique 108 et aucune ou très peu de lumière arrive sur les photodiodes 106 par réflexion, et cela quel que soit l'élément (air ou peau qui est un milieu absorbant ou diffusant pour la lumière) présent sur la partie de la surface de capture 109 recevant ces rayons. L'image formée par les photodiodes 106 se trouvant dans la zone de réflexion correspondante est donc sombre en raison de la très faible quantité de lumière arrivant dans cette zone de réflexion. L'information lumineuse arrivant dans cette zone et qui n'est pas exploitée pour la reconstruction de l'image capturée peut toutefois servir pour d'autres applications, par exemple lorsque le dispositif est configuré pour détecter la nature de l'élément imagé.

Lorsque les rayons de lumière forment un angle d'incidence supérieur à 65°, une réflexion totale se produit, et cela quel que soit l'élément (air ou peau) présent sur la partie de la surface de capture 109 recevant ces rayons. L'image formée par les photodiodes 106 se trouvant dans la zone de réflexion correspondante est donc claire étant donné que ces photodiodes 106 reçoivent la totalité ou la quasi-totalité de ces rayons de lumière (la quantité de lumière diminuant toutefois lorsque la distance entre les photo-détecteurs et la source de lumière augmente).

Enfin, lorsque ces rayons de lumière forment un angle d'incidence compris entre 41° et 65°, si de l'air est présent sur la surface de capture 109, alors un phénomène de réflexion totale se produit. Les rayons sont réfléchis à l'interface formée par la surface de capture 109 pour arriver ensuite sur les photodiodes 106. L'image obtenue de l'air est donc claire. Si de la peau est présente sur la surface de capture 109, la lumière est diffusée dans la peau, et aucune ou quasiment aucune lumière n'est réfléchie vers les photodiodes 106 (l'image de la peau donnée par les photodiodes 106 correspond à une région sombre).

Sur la figure 2, la référence 113 désigne un rayon de lumière formant, avec la normale à la surface de capture 109, le premier angle limite de réfraction égal à 41°, et la référence 115 désigne un rayon de lumière formant, avec la normale à la surface de capture 109, le deuxième angle limite de réfraction égal à 65°. Pour des raisons de lisibilité, les valeurs des angles représentés sur la figure 2 ne correspondent pas tout à fait à ces valeurs.

La partie de peau imagée lorsque la LED 110 est allumée correspond à celle se trouvant sur la région 112 de la surface de capture 109 de forme annulaire délimitée par les rayons 113 et 115. L'image correspondant formée sur la surface de détection 111 correspond à la région 114 de cette surface qui est également de forme annulaire et délimitée par les rayons 113 et 115 arrivant sur la surface de détection 111 après une réflexion contre la surface de capture 109. Le système est donc invariant par rotation autour de la LED 110.

Sur l'image obtenue par la capture lumineuse réalisée par les photodiodes 106 se trouvant au moins dans la région 114, les crêtes de l'empreinte apparaissent en foncé sur un fond clair qui représente l'air autour de l'empreinte ou les creux de l'empreinte.

La taille de l'image formée sur les photodiodes 106, c'est-à-dire les dimensions de la région 114, est plus grande que celle de la portion de peau lue qui correspond à la région 112. Un facteur de grandissement supérieur à 1, ici égal à 2, est donc obtenu avec le dispositif imageur 100. Ce grossissement de l'image est obtenu sans avoir à utiliser des moyens optiques dédiés à ce grossissement.

A l'interface entre l'élément à imager et le milieu optique 108, c'est-à-dire au niveau de la surface de capture 109, la distance entre les rayons 113 et 115, qui correspond à la différence entre le diamètre externe et le diamètre interne de l'anneau formé par la région 112, est égale à :

$$R_{peau} = h.(\tan(C_{peau/verre}) - \tan(C_{air/verre})) = h.(\tan(65°)\text{-}\tan(41°)).$$

A l'interface entre le milieu optique 108 et les photodiodes 106, c'est-à-dire au niveau de la surface de détection 111, la distance entre les premier et deuxième rayons 113, 115 après la réflexion sur la surface de capture 109, qui correspond à la différence entre le diamètre externe et le diamètre interne (c'est-à-dire la largeur) de l'anneau formé par la région 114, est égale à :

$$R_{image} = 2h.(\tan(C_{peau/verre}) - \tan(C_{air/verre})) = 2h.(\tan(65°)\text{-}\tan(41°)).$$

Le grandissement obtenu est donc égal à $G = R_{image} / R_{peau} = 2$.

Ce grandissement est égal à 2 du fait que les rayons formant l'image sur les photo-détecteurs 106 parcourent une distance égale au double de celle parcourue par les rayons de lumière entre la source lumineuse et le doigt dont l'image est capturée

Le tableau ci-dessous donne des exemples de valeurs de dimensions obtenues pour les régions 112 et 114 de forme annulaire en fonction de l'épaisseur h du milieu optique 108, avec les indices optiques mentionnés précédemment. La largeur correspond ici à la différence entre le diamètre externe et le diamètre interne d'une des régions 112 et 114.

| Epaisseur h | 1000 $\mu$m | 700 $\mu$m | 400 $\mu$m |
|---|---|---|---|
| Largeur région 114 | 2250 $\mu$m | 1785 $\mu$m | 1020 $\mu$m |
| Largeur région 112 | 1125 $\mu$m | 892 $\mu$m | 510 $\mu$m |
| Diamètre externe région 114 | 8578 $\mu$m | 6004 $\mu$m | 3431 $\mu$m |
| Diamètre externe région 112 | 4289 $\mu$m | 3002 $\mu$m | 1716 $\mu$m |

La taille de l'image de l'élément à imager obtenue sur les photo-détecteurs 106, qui correspond au champ de détection obtenu lorsqu'une des sources lumineuses 104 est allumée, est donc deux fois plus grande que celle de la région de peau 112 correspondant à cette image, et est proportionnelle à l'épaisseur h du milieu optique 108.

Dans le premier mode de réalisation du dispositif imageur 100, les sources lumineuses 104 et les photo-détecteurs 106 sont réalisés sur un même substrat 102 et sont disposés à une même distance h de la surface de capture 109 qui correspond à l'épaisseur du milieu optique 108. Cette distance h est choisie telle qu'elle soit supérieure au pas de la matrice de photo-détecteurs 106 afin que le dispositif imageur 100 ne fonctionne pas en champ proche.

Il est possible que les sources lumineuses 104 et les photo-détecteurs 106 ne soient pas disposés à une même distance de la surface de capture 109. La figure 3 représente schématiquement une telle configuration. Les matrices de sources lumineuses 104 et de photo-détecteurs 106 peuvent être vues comme étant entrelacées mais disposées sur des niveaux différents.

Sur cette figure 3, $h_{pho}$ désigne l'épaisseur de matériau du milieu optique 108 entre les photo-détecteurs 106 et la surface de capture 109, et $h_{led}$ désigne l'épaisseur de matériau du milieu optique 108 entre les sources lumineuses 104 et la surface de capture 109. On a alors :

$$R_{peau} = h_{led}.\tan(C_{peau/verre}) - h_{led}.\tan(C_{air/verre}) = h_{led}.(\tan(65°)-\tan(41°))$$

$$R_{image} = (h_{led}+h_{pho}).\tan(C_{peau/verre}) - (h_{led}+h_{pho}).\tan(C_{air/verre})$$

$$R_{image} = (h_{led}+h_{pho}).(\tan(65°)-\tan(41°)).$$

Le grandissement obtenu dans un tel dispositif imageur 100 est égal à $G = 1 + h_{pho}/h_{led}$.

Ce grandissement G ne dépend donc que de paramètres géométriques du dispositif imageur 100 et ne dépend pas de la qualité du matériau du milieu optique 108 ou de la nature de l'élément à imager. Ce grandissement G est ici toujours supérieur à 1. Ainsi, la résolution de l'image capturée par les photo-détecteurs 106 est supérieure à celle de la matrice de photo-détecteurs 106 elle-même, et cela sans utiliser de moyens optiques de grossissement dédiés.

La valeur du grandissement G peut être modifiée par exemple en jouant sur les valeurs de $h_{pho}$ et $h_{led}$. Ainsi, la valeur du grandissement G peut être rapprochée de la valeur 1 en augmentant par exemple la valeur de $h_{led}$. La valeur du grandissement G peut être augmentée en augmentant par exemple la valeur $h_{pho}$.

Sur la figure 1 qui représente une vue de dessus schématique du dispositif imageur 100, les régions 112 et 114 sont représentées telles qu'elles ne se superposent pas. Toutefois, en réalité, en considérant les valeurs d'angle limite de réfraction de 41° et 65°, ces régions 112 et 114 se superposent partiellement, c'est-à-dire que la valeur du diamètre extérieur de la région annulaire correspondant à la région 112 est inférieure à celle du diamètre intérieur de la région annulaire correspondant à la région 114.

En allumant successivement plusieurs sources lumineuses 104, plusieurs images, correspondant chacune à une partie d'élément à imager présent sur la surface de capture 109, sont capturées par les photodiodes 106. Le nombre de sources lumineuses 104 à allumer, et donc le nombre d'images à capturer, est par exemple choisi en fonction des dimensions de la zone de capture qui correspond par exemple à un carré dont les dimensions peuvent être choisies en fonction des besoins et/ou de la conception du système d'acquisition, par exemple de 5 mm $\times$ 5 mm ou de 12,8 mm $\times$ 12,8 mm. Du fait que les paramètres optiques décrits précédemment relatifs aux réflexions lumineuses se produisant dans le dispositif 100 peuvent être déterminés à l'avance (valeurs de $R_{peau}$, $R_{image}$, emplacements des régions 112 et 114, etc.), il est possible de connaître, pour chaque source lumineuse 104 qui sera allumée, les photo-détecteurs 106 qui feront partie de la région 114 associée à la source lumineuse 104 allumée. Il n'est donc pas nécessaire qu'à l'allumage de chaque source lumineuse 104, tous les photo-détecteurs 106 du dispositif imageur 100 réalisent une acquisition. Seuls les photo-détecteurs 106 inclus dans la région 114, ou formant par exemple un carré ou un rectangle incluant la région 114, peuvent réaliser cette acquisition. Il est également possible que les photo-détecteurs 106 réalisant l'acquisition soient ceux inclus dans une région plus petite que la région 114. Un plus grand nombre d'acquisitions doit dans ce cas être réalisé.

Lorsqu'un plus grand nombre de photo-détecteurs 106 que ceux appartenant à la région 114 réalisent la détection de chacune des images, un traitement numérique est réalisé après la capture de chaque image. Ainsi, les données fournies par les photo-détecteurs 106 se trouvant au centre de l'image, c'est-à-dire ceux entourés par la région 114 ainsi que par ceux se trouvant autour de la région 114 sont éliminés. Les données issues des photo-détecteurs 106 se trouvant à cheval sur la région 114 et sur le diamètre intérieur ou extérieur à la région 114 peuvent être également éliminées.

En outre, dans les différentes images obtenues en allumant successivement plusieurs sources lumineuses 104, étant donné que la position de la source lumineuse utilisée pour la capture de chacune des images est décalée, dans le plan du substrat 102, pour chacune des images obtenues, il convient de décaler également, lors de la reconstruction de l'image finale de l'élément imagé à partir des différentes images, les pixels communs des images les unes par rapport aux autres en tenant compte du grandissement G afin que les parties communes des différentes images soient correctement superposées au sein de l'image finale. Il est par exemple possible de ne conserver qu'une seule fois l'information de chaque pixel, c'est-à-dire que l'information lumineuse de chaque pixel de l'image finale est issue d'une seule image capturée. En variante, il est possible de calculer la moyenne ou la médiane des différentes captures de chaque pixel, ou bien encore d'utiliser des algorithmes de calcul plus complexes. Avant de réaliser le calcul de l'image finale, et du fait que l'intensité de la lumière décroît lorsque la distance par rapport à la LED augmente, il est avantageux de réaliser un traitement numérique des différentes images permettant de compenser ces différences d'intensité lumineuse au sein de chacune des images. Cette compensation peut être réalisée soit à partir d'un modèle prédéfini, soit en réalisant au préalable une acquisition à vide avec le dispositif 100 (sans doigt sur la surface de capture 109).

Les différentes sources lumineuses 104 allumées successivement sont choisies telles que les régions 112 capturées couvrent ensemble la totalité de la surface de l'élément à imager. En allumant, sur une ligne de la matrice de pixels, plusieurs sources lumineuses 104 (chacune permettant l'acquisition d'une image), et cela pour plusieurs lignes de la matrice de pixels, il est possible de couvrir une majeure partie de cette surface de l'élément à capturer. Toutefois, étant donné la forme de la région 112 qui correspond à un anneau, il est avantageux d'allumer certaines sources lumineuses 104 se trouvant sur les bords verticaux de la matrice de pixels du dispositif imageur 100 et/ou dans les coins de cette matrice, afin de perdre le moins de surface de détection possible.

En variante, il est également possible que lors de la capture réalisée pour chaque source lumineuse 104 allumée, seule une partie des photo-détecteurs 106 se trouvant dans la région 114, par exemple des groupes de photo-détecteurs 106 formant ensemble des rectangles disposés au sein de la région 114, réalisent une détection de la lumière reçue. Selon une autre variante, il est par exemple également possible de lire un ou plusieurs photo-détecteurs 106 se trouvant dans la région 114, à l'allumage de chaque source lumineuse 104, le nombre d'acquisitions d'image étant dans ce cas plus important.

Le dispositif imageur 100 décrit ci-dessus en lien avec la figure 1 peut comporter des photodiodes 106 et des LEDs 104 réalisées en technologie CMOS. Les LEDs 104 peuvent avantageusement être réalisées à partir de GaN reporté sur le substrat 102 de silicium comprenant les photo-détecteurs 106 réalisés en CMOS (ainsi que l'électronique de lecture, voire l'électronique de traitement).

Les photo-détecteurs 106 et les sources lumineuses 104 forment par exemple des pixels (chaque pixel comportant un photo-détecteur 106, une source lumineuse 104 telle qu'une LED de dimension égale à $10 \times 10\ \mu m^2$ ou $3 \times 3\ \mu m^2$, des transistors, etc.) de dimension égale à $50 \times 50\ \mu m^2$. Dans ce cas, avec un grandissement G égal à 2, la résolution de l'image finale obtenue est équivalente à 1000 ppp tandis que la résolution des pixels du dispositif imageur 100 est de 500 ppp. Ainsi, en considérant un carré incluant une région de détection 114 comprenant 120 pixels x 120 pixels (chacun de dimension $50 \times 50\ \mu m^2$), soit $6000 \times 6000\ \mu m^2$ et incluant donc un anneau de 6 mm de diamètre extérieur correspondant à la région utile pour un milieu optique 108 correspondant à un verre d'épaisseur égale à 700 $\mu m$, la région de capture 112 du dispositif imageur 100 peut correspondre à un carré de dimension égale à $3000 \times 3000\ \mu m^2$.

Avec les dimensions de pixels indiquées ci-dessus et avec un milieu optique 108 correspondant à du verre d'épaisseur égale à 700 $\mu m$, il est possible d'allumer par exemple, sur une même ligne de pixels, une LED 104 tous les 8 pixels (afin d'avoir un décalage de capture correspondant à la moitié de la largeur de l'anneau formé par la région 112), voire tous les 9 ou 10 pixels, afin que les images partielles obtenues forment ensemble la partie de l'image finale correspondant à cette ligne de pixels. Avec une telle lecture, seule une ligne de pixels sur 50, ou 55 voire même 60, est suffisante pour obtenir l'ensemble des images partielles permettant la reconstruction de l'image finale incluant la totalité de la surface de capture. D'autres pas et d'autres tailles de région de capture/détection sont possibles, un recouvrement suffisant des images permettant l'obtention de l'image finale.

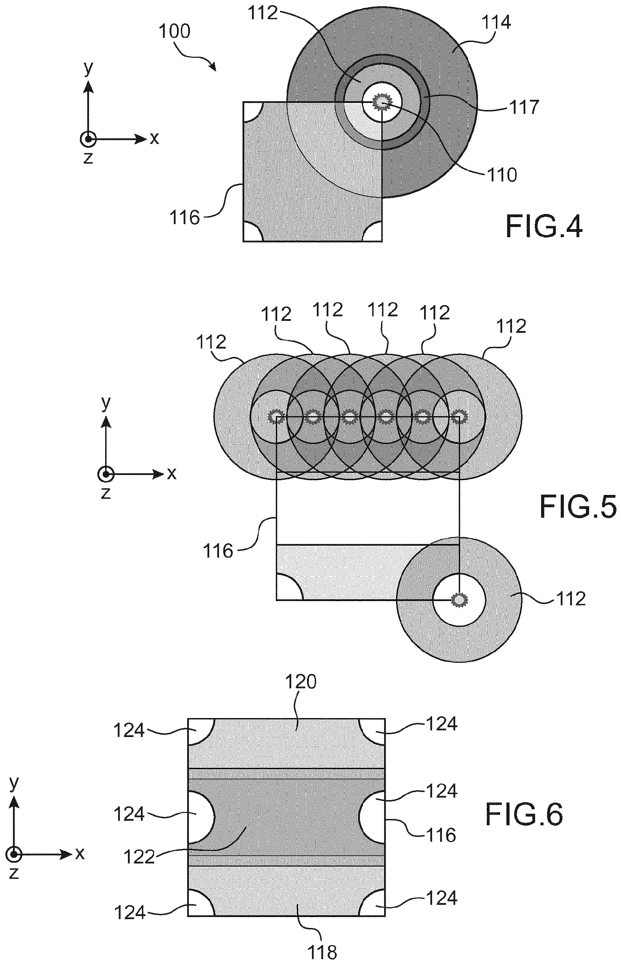

La figure 4 représente les régions 112 et 114 obtenues dans la configuration particulière décrite ci-dessus (grandissement G égal à 2, milieu optique 108 correspondant à une plaque de verre d'épaisseur égale à 700 $\mu m$). La région de peau se trouvant sur la surface de capture 109 et qui est destinée à être détectée correspond ici à un carré de dimensions égales à $4,4 \times 4,4\ mm^2$ référencé 116. Sur la figure 4, les régions 112 et 114 se chevauchent partiellement au niveau d'une région référencée 117. En outre, ces régions 112 et 114 représentées sur la figure 4 correspondent à celles obtenues avec une source lumineuse 110 allumée positionnée dans le coin supérieur droit de la région 116 à imager. Enfin, la figure 4 illustre le fait que les coins de la région 116 ne peuvent pas être détectés par les photo-détecteurs 106 se trouvant dans la région 116 car même en allumant les sources lumineuses se trouvant dans ces coins, ces derniers sont illuminés par des rayons formant, avec la surface de capture 109, un angle d'incidence inférieur au premier angle limite de réfraction.

Dans cette configuration, il est par exemple possible de réaliser tout d'abord la capture de bandes supérieure et inférieure de la région 116 en allumant successivement les sources lumineuses 104 se trouvant dans les pixels formant les bords supérieur et inférieur de la région 116. Pour chacune de ces bandes, une source lumineuse 104 tous les 8 pixels peut être par exemple allumée, soit 12 sources lumineuses 104 par bande.

La figure 5 représente schématiquement une partie des régions 112 imagées lors d'une capture de ces bandes supérieure et inférieure de la région 116.

De manière avantageuse, les sources lumineuses 104 qui sont allumées sont choisies afin que chacune des différentes régions 112 capturées ait un recouvrement avec une ou plusieurs autres régions 112.

La capture d'une bande centrale de la région 116 peut être réalisée en allumant les sources lumineuses 104 (par exemple une tous les 8 pixels) d'une ligne se trouvant sensiblement au centre de la région 116.

La figure 6 représente les parties de la région 116 capturées à ce stade et qui correspondent à 36 images partielles de l'empreinte. Les références 118, 120 et 122 désignent respectivement les bandes inférieure, supérieure et centrale de la région 116 (avec un faible recouvrement entre les parties 118 et 122, ainsi qu'entre les parties 120 et 122). En outre, la référence 124 désigne les coins des régions 116 ainsi que les parties des bords de la région centrale 122 qui ne sont pas capturés lors de la lecture des trois bandes 118, 120 et 122.

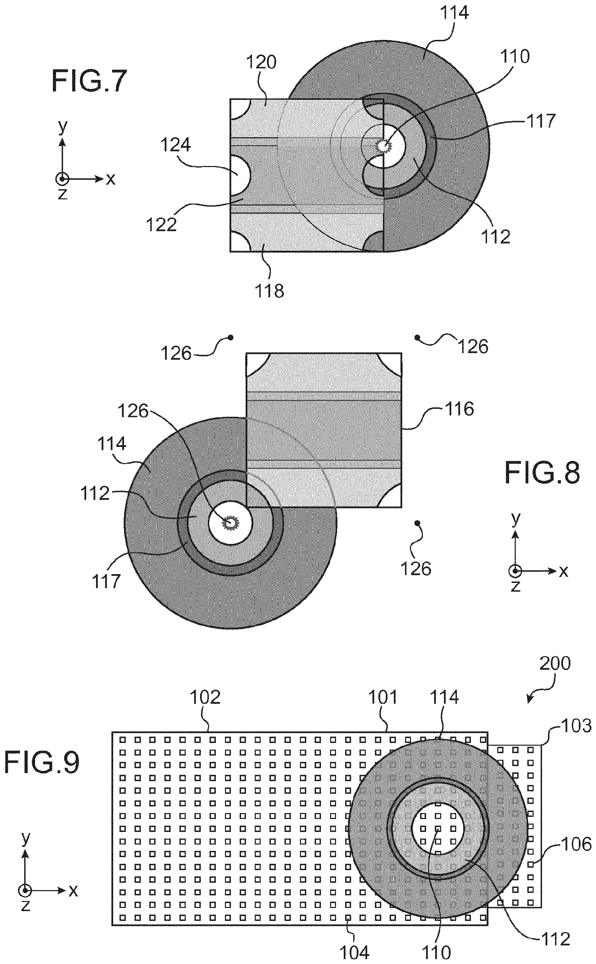

Les parties 124 des bords de la région centrale 122 non capturées par les étapes mises en oeuvre précédemment peuvent l'être en allumant des sources lumineuses 104, par exemple au nombre de quatre, se trouvant au niveau des bords de la région 122. La figure 7 représente les régions 112 et 114 obtenues en allumant une de ces sources lumineuses, référencée 110 sur la figure 7, et qui permet de capturer partiellement une de ces parties 124 non capturées initialement lors de l'acquisition de la bande centrale 122. A ce stade de l'acquisition, 40 images partielles de l'empreinte ont été obtenues.

Ensuite, pour réaliser la lecture des coins de la région 116, il est possible de réaliser le dispositif imageur 100 tel qu'il comporte, en plus de la matrice de sources lumineuses 104, au moins quatre sources lumineuses supplémentaires 126 se trouvant en dehors de la matrice formée par les sources lumineuses 104, et disposées chacune le long d'une bissectrice de l'angle d'un des autre coins de la région 116. La figure 8 représente schématiquement ces quatre LEDs 126 qui permettent de réaliser l'acquisition des coins de la région 116. Avec un dispositif imageur 100 ayant les dimensions précédemment décrites, chacune des sources lumineuses supplémentaires 126 est par exemple disposée à une distance égale à environ 600 $\mu$m du coin le plus proche de la matrice. Il est également possible que plusieurs sources lumineuses supplémentaires 126 soient disposées le long de chacune des bissectrices des angles des coins de la matrice de sources lumineuses 104, à différentes distances par rapport à ces coins. Ainsi, en fonction de l'épaisseur du milieu optique 108, il est possible d'utiliser, pour l'acquisition de chaque coin, la source lumineuse supplémentaire 126 se trouvant à la distance adéquate de la matrice pour réaliser cette acquisition.

En variante, notamment lorsque le dispositif imageur 100 est de taille importante, il est possible de ne pas lire les coins de la région 116.

D'autres méthodes de lecture de la région 116 que celle décrite ci-dessus sont possibles. Par exemple, il est possible qu'à l'allumage de chacune des sources lumineuses 104, seule une partie de la région 114 soit lue par les photo-détecteurs 106, par exemple une ou plusieurs parties de forme carrée inclues dans la région 114, voire même uniquement un ou quelques photo-détecteurs 106 inclus dans la région 114. La séquence d'allumage des sources lumineuses 104 est dans ce cas adaptée afin d'avoir un certain recouvrement entre les différentes images capturées.

Dans les exemples donnés ci-dessus, chacun des pixels (qui comporte une source lumineuse 104 et un photo-détecteur 106) a une dimension égale à environ 50 $\mu$m $\times$ 50 $\mu$m². Ces dimensions peuvent être différentes : par exemple chaque pixel peut avoir des dimensions égales à environ 25 $\mu$m $\times$ 25 $\mu$m, voire même égale à 12,5 $\mu$m $\times$ 12,5 $\mu$m.

Enfin, si des informations sont manquantes pour un ou plusieurs pixels de l'image finale, il est possible de mettre en oeuvre une interpolation afin de calculer ces informations.

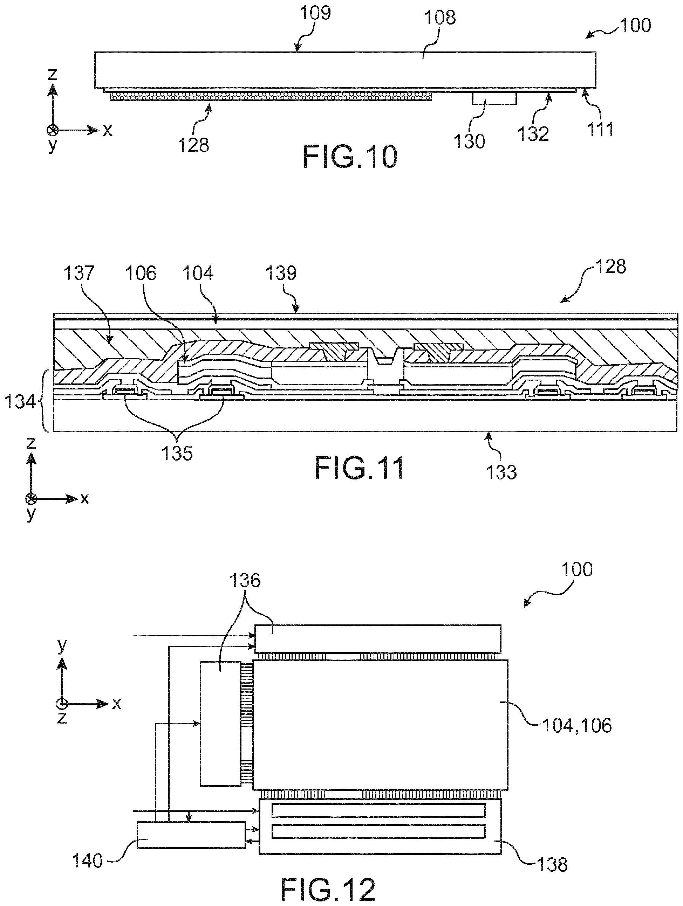

La figure 12 représente une vue de dessus du dispositif imageur 100, ici selon le premier mode de réalisation, sur laquelle les moyens de commande et de lecture configurés pour allumer et éteindre successivement chacune des sources lumineuses 104 et, au cours de l'allumage de chacune des sources lumineuses 104, à lire les photo-détecteurs 106 et commander l'acquisition par les photo-détecteurs 106 d'une image partielle de l'élément à imager sont visibles. Ces moyens de commande comportent par exemple ici des circuits 136 d'adressage des sources lumineuses 104 et des photo-détecteurs 106. Le dispositif imageur 100 comporte également des moyens 138 de traitement des informations capturées par les photo-détecteurs 106. Ces moyens 138 sont par exemple ceux construisant les différentes images partielles obtenues puis calculant l'image finale de l'empreinte capturée, à partir des différentes images partielles. Enfin, le dispositif imageur 100 comporte également un élément de contrôle 140 relié aux circuits 136 et aux moyens 138 et commandant ces éléments.

La figure 9 représente un dispositif imageur 200 selon un autre exemple de réalisation.

Contrairement au dispositif imageur 200 selon le premier mode de réalisation dans lequel les matrices de photo-détecteurs 106 et de sources lumineuses 104 sont entrelacées l'une avec l'autre, la matrice de photo-détecteurs 106 du dispositif imageur 200 est disposée à côté de la matrice de sources lumineuses 104, dans une partie capteur 103 du dispositif 200 distincte d'une partie affichage 101 du dispositif 200. Typiquement, la partie affichage 101 peut correspondre à un écran d'un dispositif électronique, par exemple un smartphone, au bord duquel la partie capteur 103 est disposée. La partie capteur 103 peut être juxtaposée ou non à la partie affichage 101.

Sur la figure 9, les régions 112 et 114 obtenues lors de l'allumage d'une des sources lumineuses 104, référencée 110 sur cette figure, sont représentées. En allumant plusieurs sources lumineuses 104 de la même colonne que la source lumineuse 110, il est possible de réaliser la capture d'une région de l'élément à imager se trouvant sur la partie affichage 101, au niveau du bord juxtaposé à la partie capteur 103. Une capture supplémentaire peut également être réalisée en utilisant les sources lumineuses 104 d'une ou plusieurs autres colonnes de la partie affichage 101, cette ou ces colonnes restant proches de la partie capteur 103 afin que la région 114 se retrouve bien au moins partiellement sur la partie capteur 103.

En utilisant comme milieu optique 108 une plaque de verre d'épaisseur égale à environ 700 $\mu$m, il est possible d'obtenir une région 114 de largeur égale à environ 1725 $\mu$m (ce qui correspond à 34 pixels chacun de largeur égale à

50 μm) lorsqu'une seule colonne de sources lumineuses 104 est utilisée. Dans cette configuration, la distance entre les sources lumineuses 104 de la colonne utilisées et la région 114 est égale à 1217 μm.

En outre, dans le dispositif 200, il est avantageux d'avoir un milieu optique 108 épais, par exemple obtenu en superposant deux (ou plus) lames de verre, permettant par exemple l'obtention d'un milieu optique 108 d'épaisseur supérieure ou égale à 1 mm.

Dans la configuration représentée sur la figure 9, la partie capteur 103 est disposée à côté de la partie affichage 101. En variante, si la partie affichage 101 est réalisée telle qu'elle forme un écran au moins partiellement transparent, c'est-à-dire apte à être traversé par une partie de la lumière reçue, la partie capteur 103 peut être disposée sous cet écran. Dans ce cas, les matrices de sources lumineuses et de photo-détecteurs peuvent être vues comme étant entrelacées mais disposées sur des niveaux différents.

Le dispositif 200 est de préférence tel que la partie affichage 101 soit réalisée avec des sources lumineuses 104 de type OLED, et avantageusement tel que l'émission de lumière soit réalisée à travers le substrat 102 (par exemple en verre) sur lequel les sources lumineuses 104 sont réalisées (« bottom émission », ou émission par l'arrière) et à travers le milieu optique 108. En configuration émission par l'arrière, les pistes conductrices transparentes, comprenant par exemple de l'ITO, du substrat 102 sur lequel les sources lumineuses 104 sont réalisées peuvent être utilisées pour connecter la partie capteur 103. Les niveaux métalliques supérieurs peuvent également être utilisés.

Il est également possible de réaliser le dispositif 200 tel que des trous transparents soient présents au sein de la partie affichage 101, la partie capteur 103 pouvant dans ce cas être reportée sur la partie affichage 101 en disposant les photo-détecteurs 106 en regard des trous transparents.

La figure 10 représente le dispositif imageur 100 selon un deuxième mode de réalisation. Dans ce deuxième mode de réalisation, le milieu optique 108 correspond au substrat transparent utilisé pour la réalisation de transistors TFT servant à l'adressage des pixels du dispositif 100, et qui font partie des moyens de commande du dispositif imageur 100. Sur la figure 10, la référence 128 désigne l'ensemble formé du côté de la surface de détection 111 et qui comporte les transistors TFT d'adressage, les sources lumineuses 104 de type OLED émettant leur lumière du côté de leur face arrière, et les photo-détecteurs 106 qui sont par exemple des photodiodes PIN. Une ou plusieurs puces électroniques 130 pilotant par exemple l'allumage des sources lumineuses 104 et/ou la lecture par les photo-détecteurs 106 sont disposées également du côté de la surface de détection 111, à côté de l'ensemble 128. Ainsi, l'autre face du substrat formant le milieu optique 108 reste libre et forme la surface de capture 109 sur laquelle l'élément à imager, typiquement un doigt, est destiné à se trouver. Une couche d'interconnexion 132 est présente entre le milieu optique 108 est ces éléments 128, 130.

Dans ce deuxième mode de réalisation, le milieu optique 108 peut avoir une épaisseur supérieure ou égale à environ 1 mm, par exemple comprise entre environ 1 mm et 2 mm. Un tel milieu optique 108 épais est par exemple obtenu en collant plusieurs lames de même indice optique avec un adhésif, ou colle, ayant également ce même indice optique afin de ne pas avoir de réflexion à l'interface formée par la colle.

En outre, il est possible que les sources lumineuses 104 de type OLED réalisent une émission lumineuses depuis leur face avant, la lumière émise ne traversant que le milieu optique 108 reporté sur ces sources lumineuses 104 et non le substrat 102.

Le dispositif 100 selon ce deuxième mode de réalisation peut être tel qu'il soit de dimensions importantes et configuré pour réaliser une capture simultanée des empreintes digitales de plusieurs doigts ou encore d'une main entière. Dans ce cas, un milieu optique 108 d'épaisseur importante, par exemple supérieure à environ 1 mm, permet d'assurer une certaine solidité au dispositif 100.

La figure 11 représente l'empilement technologique réalisé pour former un tel ensemble 128. La référence 133 désigne la face de cet ensemble 128 qui est destinée à se trouver du côté du milieu optique 108. Tout d'abord, une partie 134 comportant des transistors TFT d'adressage 135 est réalisée à partir de silicium polycristallin. Ces transistors TFT 135 peuvent également être réalisés à partir de silicium amorphe ou d'IGZO. Le silicium polycristallin est de préférence utilisé car il permet l'obtention de meilleures performances électriques, ce qui permet de réduire la taille des transistors TFT. Cette partie 134 inclut également les différentes lignes d'interconnexions électriques du dispositif imageur 100.

L'empilement de couches formant les photo-détecteurs 106, par exemple des diodes PIN, est ensuite formé sur la partie 134. Du silicium amorphe peut être avantageusement utilisé pour la réalisation de ces diodes PIN. Les électrodes des diodes PIN se trouvant du côté des transistors TFT peuvent être formées par une couche conductrice dédiée à ces électrodes, ou être formées au sein d'un niveau de métal commun aux transistors. Les électrodes des diodes PIN se trouvant du côté des sources lumineuses 104 sont réalisées à partir d'un matériau électriquement conducteur et par exemple opaque.

Un matériau isolant planarisant 137 est ensuite déposé sur l'ensemble réalisé, formant une surface plane sur laquelle les sources lumineuses 104 de type OLED sont ensuite réalisées. La réalisation des diodes de type OLED comporte notamment la mise en oeuvre d'un dépôt et d'une lithographie d'un matériau conducteur pour former les anodes, puis le dépôt de couches organiques émissives, et la réalisation d'une cathode communes aux diodes. Réaliser les diodes OLED après les autres éléments du dispositif imageur 100 permet de ne pas exposer les matériaux utilisés pour former les diodes OLED aux températures et solvants utilisés pour la réalisation des précédents éléments. La structure OLED réalisée est transparente, avec par exemple une couche métallique formant un miroir disposée sur la cathode pour réfléchir la lumière, et l'émission de lumière réalisée peut être monochrome (n'importe quelle longueur d'onde de toute la gamme visible, UV et IR), ou blanche grâce à un empilement vertical de deux ou trois couleurs émises.

Un matériau d'encapsulation 139 est ensuite déposé sur l'ensemble réalisé.

Des transistors TFT peuvent être disposés en périphérie de la matrice de sources lumineuses 104 et de photo-détecteurs 106 pour former les moyens servant à la commande et/ou à la lecture et ainsi limiter le nombre d'entrée/sorties à réaliser vers les circuits externes de commande réalisé en technologie silicium, par exemple en CMOS.

Dans un dispositif imageur 100 réalisé avec des sources lumineuses 104 de type OLED et des moyens de commande comprenant des transistors TFT, chaque source lumineuse 104 de type OLED peut être commandée par deux transistors TFT (un premier pour sélectionner le pixel, et un deuxième pour alimenter la diode OLED) dans le cas d'une matrice active (solution AMOLED), ou bien être commandée par une matrice passive formant une grille avec des lignes et des colonnes de lignes conductrices permettant un allumage de la diode OLED lorsque la tension d'allumage est appliquée sur la ligne et la colonne correspondantes à cette diode (solution PMOLED). Chaque photo-détecteur 106 de type diode PIN peut être commandé par un autre transistor TFT (dans le cas d'une lecture dite passive), ou par plusieurs autres transistors TFT dans le cas d'une lecture dite active.

Dans les dispositifs imageurs 100 précédemment décrits, la valeur du deuxième angle limite de réfraction est obtenue en considérant un indice optique de peau égal à 1,37. Lorsqu'une des sources lumineuses 104 est allumée, en connaissant les photo-détecteurs 106 destinés à recevoir les rayons formant le bord extérieur de la région 114, il est possible de réaliser une estimation de l'indice optique des deux milieux présents sur la surface de capture 109, cette estimation étant ensuite utilisée pour vérifier que ces indices optiques correspondent bien à celui de l'air (indice optique égal à 1) et de la peau (indice optique de valeur comprise dans une gamme prédéterminée). Cela permet de détecter si la peau éclairée par cette source lumineuse correspond à de la peau véritable, ou si cette peau est artificielle. Le dispositif imageur 100 est donc bien adapté pour réaliser une détection de fraude lorsque ce dispositif 100 est utilisé en tant que capteur d'empreinte digitale. Il est également possible d'estimer l'indice optique de l'élément imagé à partir des dimensions de la région 114.

Dans tous les modes de réalisation, le milieu optique 108 peut correspondre à plusieurs couches de matériau transparent superposées. Par exemple, si le smartphone dans lequel le dispositif imageur 100 est réalisé comporte initialement un verre d'épaisseur inférieur à celle souhaitée pour avoir un bon fonctionnement du dispositif imageur 100, il est possible de rajouter un verre de protection supplémentaire permettant de former, avec le verre initial, un milieu optique 108 ayant l'épaisseur souhaitée. Dans ce cas, les matériaux utilisés pour former le milieu optique 108, le verre de protection supplémentaire et la colle entre ces deux éléments sont choisis pour que leurs indices optiques soient le plus proche possible les uns des autres afin de limiter au maximum les réflexions aux interfaces de ces différents éléments.

Dans tous les modes de réalisation, il est possible que le capteur 100 comporte un système de filtrage permettant de limiter ou éviter les perturbations qui seraient dues à l'éclairage du capteur 100 par la lumière extérieure à celui-ci. Ce système de filtrage peut correspondre par exemple à une paire de filtres polarisants, ou bien des filtres en longueur d'onde ou encore des filtres angulaires ne laissant passer que les rayons lumineux ayant une certaine valeur d'angle d'incidence.

En outre, dans tous les modes de réalisation, le capteur 100 peut être utilisé pour réaliser une capture d'empreinte statique, c'est-à-dire avec un doigt ne bougeant pas sur le milieu optique 108, ou bien pour former un capteur à balayage, c'est-à-dire adapté à capturer l'empreinte d'un doigt en mouvement sur le milieu optique 108. Dans le cas d'un capteur à balayage, un nombre de sources lumineuses 104 moins important peut être utilisé par rapport à un capteur d'empreinte statique car l'image n'a pas besoin d'avoir une dimension importante dans le sens du déplacement du doigt. En outre, lors du calcul de l'image finale réalisé à partir des images partielles capturées, le déplacement de l'élément à imager réalisé entre la capture de chacune des images partielles sera calculé et pris en compte. Pour construire l'image finale, une capture d'images partielles est suffisante car le doigt se déplace entre deux acquisitions d'images partielles.

En outre, même si le dispositif imageur 100 peut être utilisé avantageusement pour former un capteur d'empreinte digitale, il est également possible d'utiliser le dispositif imageur 100 comme dispositif de détection de mouvement de l'élément à imager pour former par exemple un dispositif de pointage, ou pavé tactile.

De manière générale, les photo-détecteurs 106 du dispositif imageur 100 utilisés lors des captures d'images reçoivent une quantité importante de lumière provenant des sources de lumière 104. Ainsi, les temps d'intégration du dispositif imageur 100 sont courts. Par exemple, lorsque le dispositif imageur 100 forme un capteur ayant une résolution de pixels de 500 ppp, l'acquisition de l'image complète (obtenue en allumant 32 sources lumineuses) est réalisée en un peu moins de 50 ms.

Dans tous les modes de réalisation, étant donné qu'un même point de peau peut être lu par plusieurs couples différents photo-détecteur 106/source lumineuse 104, une défaillance d'un de ces couples peut être compensée en utilisant un autre de ces couples. Ainsi, les éventuels défauts de fabrication de certains pixels peuvent être compensés, ce qui limite l'impact des erreurs obtenues à la lecture de l'empreinte. En outre, le dispositif 100 reste fonctionnel même si certains pixels ne fonctionnent plus. Par exemple, si un pixel défaillant correspond à l'un de ceux dont la LED n'est pas destinée à être allumée pour capturer une partie de l'empreinte, alors l'information non capturée par ce pixel peut être obtenue à partir d'une autre image recouvrant partiellement celle comprenant le pixel défaillant. Si le pixel défaillant correspond à l'un de ceux dont la LED est destinée à être allumée pour capturer une partie de l'empreinte, il est possible de faire appel à un pixel voisin dont la LED pourra être allumée et réaliser une capture d'une partie de l'empreinte.

Dans le cas d'un dispositif imageur 100 de taille importante, par exemple réalisé avec des sources lumineuses 104 de type OLED, il est envisageable, lors de la capture d'image, d'allumer plusieurs sources lumineuses 104 simultanément à condition que ces sources lumineuses 104 soient suffisamment éloignées l'une de l'autre afin que les rayons de lumière provenant d'une des sources lumineuses 104 et arrivant dans une région 114 prévue pour être éclairée par des rayons provenant d'une autre source lumineuse 104 aient une intensité négligeable. De manière avantageuse, ces sources lumineuses 104 suffisamment éloignées et allumées simultanément sont disposées sur une même ligne, ce qui permet de réduire la durée globale de capture de l'élément à imager lorsque le dispositif imageur 100 est configuré pour lire tous les pixels d'une même ligne simultanément.

Dans les différents modes et exemples de réalisation précédemment décrits, lorsque les matrices de sources lumineuses 104 et de photo-détecteurs 106 sont entrelacées, chaque pixel peut comporter une des sources lumineuses 104 et un des photo-détecteurs 106.

En variante, il est possible que chaque pixel comporte soit une source lumineuse 104, soit un photo-détecteur 106. En effet, étant donné que chaque pixel de l'image finale peut être vu par plusieurs couples photo-détecteur/source lumineuse, il existe de la redondance dans les informations capturées et il n'est donc pas nécessaire d'avoir un couple photo-détecteur/source lumineuse au sein de chacun des pixels du dispositif 100. Ainsi, il est possible d'avoir périodiquement, au sein de la matrice, des pixels ne comportant pas de photodiodes afin de libérer de l'espace pour la réalisation des sources lumineuses.

Dans tous les modes de réalisation précédemment décrits, la capture réalisée par le dispositif imageur 100 permet l'obtention d'une image finale monochrome, les sources lumineuses 104 pouvant être réalisées telles qu'elles émettent une lumière selon une même longueur d'onde (par exemple de couleur rouge ou verte). Toutefois, étant donné que l'acquisition lumineuse se base sur le phénomène de réflexion totale frustrée, la formation de l'image ne dépend pas ou peu de la longueur d'onde de la lumière. Il est toutefois possible d'en tenir compte pendant la reconstruction de l'image finale afin de limiter l'impact des aberrations chromatiques.

Il est toutefois possible de réaliser le dispositif imageur 100 tel que l'image acquise soit en couleurs via l'utilisation de sources lumineuses 104 émettant des lumières de couleurs différentes. Par exemple, il est possible d'avoir, d'une ligne à l'autre de la matrice de sources lumineuses 104, des sources lumineuses 104 émettant une lumière de longueurs d'onde différentes. Ainsi, une première ligne de sources lumineuses 104 peut émettre une lumière verte, une deuxième ligne de sources lumineuses 104 peut émettre une lumière rouge, une troisième ligne de sources lumineuses 104 peut émettre une lumière bleue, et cela pour toutes les lignes de la matrice de sources lumineuses 104.

En outre, les sources lumineuses 104 peuvent être partagées entre plusieurs photo-détecteurs 106 disposés côte à côte, en réalisant par exemple chacune des sources lumineuses 104 au centre d'un groupe de quatre pixels comportant chacun un photo-détecteur 106.

Selon une autre variante, il est également possible, notamment lorsque le dispositif imageur est réalisé en technologie CMOS, de réaliser chaque pixel tel qu'il comporte un photo-détecteur 106 et trois sources lumineuses 104 chacune configurée pour émettre une lumière de couleur rouge, verte ou bleue. Ainsi, la partie capteur du dispositif imageur 100 forme un afficheur couleur pouvant se confondre par exemple avec le reste de l'écran du smartphone dans lequel le dispositif imageur 100 est intégré.

Il est également possible d'avoir un dispositif imageur 100 servant par exemple de « flash », c'est-à-dire configuré pour émettre une lumière blanche de forte intensité. Un tel dispositif imageur 100 peut dans ce cas être disposé du côté arrière du dispositif électronique de type smartphone, ce flash servant par exemple lors de la prise de photographie.

Dans les différents modes de réalisation précédemment décrits, les surfaces de capture 109 et de détection 111 formées par les faces supérieure et inférieure du milieu optique 108 sont sensiblement planes. Il est toutefois possible d'envisager d'avoir au moins l'une de ces surfaces, notamment la surface de capture 109, qui soit concave ou convexe. Il convient dans ce cas de prendre en compte le rayon de courbure de cette face qui influence la réflexion des rayons lumineux sur cette face, et donc le choix des photo-détecteurs 106 à utiliser pour l'acquisition de chacune des images partielles de l'élément à imager, ainsi que les facteurs de grandissement ou de distorsion associés. Comme ces paramètres sont stables, une calibration du système peut être avantageusement mise en oeuvre en production.

Dans les différents modes de réalisation décrits, il est possible de contrôler l'angle d'émission lumineuse des LEDs, par exemple via le dépôt d'une couche d'indice optique faible devant le doigt, telle que l'angle limite entre cette couche et le verre corresponde à la valeur d'angle souhaitée. Un tel contrôle peut par exemple servir à allumer simultanément deux sources lumineuses qui ne seraient pas suffisamment éloignées l'une de l'autre pour ne pas interférer l'une avec l'autre.

**Revendications**

1. Dispositif imageur optique (100) comportant au moins :

   - une matrice de sources lumineuses (104) réalisée sur un substrat (102) et formant un écran d'affichage,
   - une matrice de photo-détecteurs (106) réalisée sur le substrat (102) et entrelacée avec la matrice de sources lumineuses (104),
   - un milieu optique (108) recouvrant les sources lumineuses (104) et les photo-détecteurs (106), à travers lequel une lumière destinée à être émise par les sources lumineuses (104) est apte à se propager, et formant une surface de capture (109) contre laquelle un élément à imager est destiné à être disposé et une surface de détection (111) sensiblement parallèle à la surface de capture (109) et contre laquelle les matrices de sources lumineuses (104) et de photo-détecteurs (106) sont disposées,
   **caractérisé en ce que** le milieu optique (108) a une épaisseur supérieure au pas des photo-détecteurs (106) de la matrice de photo-détecteurs (106),
   et **en ce que** le dispositif imageur optique (100) comporte en outre des moyens de commande et de lecture (134, 136, 138, 140) configurés pour allumer et éteindre successivement chacune d'une partie des sources lumineuses (104) et, au cours de l'allumage de chacune de ladite partie des sources lumineuses (104), à lire au moins une partie des photo-détecteurs (106) destinés à recevoir des rayons (113, 115) de lumière issus de la source lumineuse (104) allumée et ayant subi une réflexion contre la surface de capture (109) en formant, avec la surface de capture (109), un angle d'incidence estimé en fonction du milieu optique (108) et de l'élément à imager,
   et **en ce que** chacune des sources lumineuses (104) est configurée pour former, sur la surface de détection (111), une région (114) dont la taille est supérieure à au moins deux fois la taille d'une surface émettrice de la source lumineuse,
   et **en ce que** la valeur de l'angle d'incidence est comprise entre, ou égale à, celle d'un premier angle limite de réfraction défini par l'indice optique du milieu optique (108) et l'indice optique de l'atmosphère dans laquelle se trouve l'élément à imager, et celle d'un deuxième angle limite de réfraction défini par l'indice optique du milieu optique (108) et un indice optique supplémentaire de valeur supérieure à celle de l'indice optique de l'atmosphère dans laquelle se trouve l'élément à imager et inférieure ou égale à celle de l'indice optique de l'élément à imager.

2. Dispositif imageur optique (100) selon la revendication 1, dans lequel les moyens de commande et de lecture (134, 136, 138, 140) sont configurés pour lire, au cours de l'allumage de chacune de ladite partie des sources lumineuses (104), les photo-détecteurs (106) se trouvant dans la région (114) de la surface de détection (111) qui est de forme annulaire et délimitée par les rayons (113, 115) de lumière réfléchis formant, contre la surface de capture (109), les premier et deuxième angles limites de réfraction.

3. Dispositif imageur optique (100) selon l'une des revendications précédentes, dans lequel les moyens de commande et de lecture (134, 136, 138, 140) sont configurés tels que les photo-détecteurs (106) lus au cours de l'allumage de chacune de la partie des sources lumineuses (104) délivrent une image partielle de l'élément à imager telle que chacune des images partielles obtenues se recouvre partiellement avec au moins une autre des images partielles de l'élément à imager.

4. Dispositif imageur optique (100) selon la revendication 3, comportant en outre des moyens de calcul d'une image finale de l'élément à imager à partir des images partielles de l'élément à imager.

5. Dispositif imageur optique (100) selon l'une des revendications précédentes, comportant en outre des sources lumineuses supplémentaires (126) disposées hors de la matrice de sources lumineuses (104) et alignées avec des bissectrices des angles formés par les coins de la matrice de sources lumineuses (104).

6. Dispositif imageur optique (100) selon l'une des revendications précédentes, dans lequel chaque pixel de l'écran d'affichage comporte une des sources lumineuses (104) et un des photo-détecteurs (106).

7. Dispositif imageur optique (100) selon l'une des revendications précédentes, dans lequel les sources lumineuses (104) sont formées par des LED et les moyens de commande et de lecture (134, 136, 138, 140) comportent des transistors CMOS, ou dans lequel les sources lumineuses (104) sont de type OLED et les moyens de commande et de lecture (134, 136, 138, 140) comportent des transistors TFT disposés de manière entrelacée avec la matrice de photo-détecteurs (106).

8. Dispositif imageur optique (100) selon la revendication 7, dans lequel, lorsque les sources lumineuses (104) sont de type OLED et que les moyens de commande et de lecture (134, 136, 138, 140) comportent des transistors TFT, lesdits transistors TFT sont réalisés sur le substrat (102) qui est transparent et qui forme le milieu optique (108).

9. Dispositif imageur optique (100) selon l'une des revendications précédentes, dans lequel l'épaisseur du milieu optique (108) est supérieure à 50 $\mu$m, ou dans lequel le milieu optique (108) comporte une plaque de verre d'épaisseur supérieure ou égale à 700 $\mu$m.

10. Procédé de capture d'images mis en oeuvre avec un dispositif imageur optique (100) comportant au moins :

- une matrice de sources lumineuses (104), réalisée sur un substrat (102) et formant un écran d'affichage,
- une matrice de photo-détecteurs (106) réalisée sur le substrat (102) et entrelacée avec la matrice de sources lumineuses (104),
- un milieu optique (108) recouvrant les sources lumineuses (104) et les photo-détecteurs (106), à travers lequel une lumière destinée à être émise par les sources lumineuses (104) est apte à se propager, et formant une surface de capture (109) contre laquelle un élément à imager est destiné à être disposé et une surface de détection (111) sensiblement parallèle à la surface de capture (109) et contre laquelle les matrices de sources lumineuses (104) et de photo-détecteurs (106) sont disposées,
**caractérisé en ce que** le milieu optique (108) a une épaisseur supérieure au pas des photo-détecteurs (106) de la matrice de photo-détecteurs (106),
et **en ce que** chacune des sources lumineuses (104) du dispositif imageur optique (100) est configurée pour former, sur la surface de détection (111), une région (114) dont la taille est supérieure à au moins deux fois la taille d'une surface émettrice de la source lumineuse,
le procédé de capture d'images comportant la mise en oeuvre, par des moyens de commande et de lecture (134, 136, 138, 140) du dispositif imageur optique (100), des étapes suivantes :

a) allumage d'une des sources lumineuses (104),
b) lecture d'au moins une partie des photo-détecteurs (106) recevant des rayons (113, 115) de lumière issus de la source lumineuse (104) allumée et ayant subi une réflexion contre la surface de capture (109) en formant, avec la surface de capture (109), un angle d'incidence estimé en fonction du milieu optique (108) et de l'élément à imager,
c) extinction de la source lumineuse (104) allumée,

les étapes a) à c) étant répétées pour chacune d'une partie des sources lumineuses (104),
et **en ce que** la valeur de l'angle d'incidence est comprise entre, ou égale à, celle d'un premier angle limite de réfraction défini par l'indice optique du milieu optique (108) et l'indice optique de l'atmosphère dans laquelle se trouve l'élément à imager, et celle d'un deuxième angle limite de réfraction défini par l'indice optique du milieu optique (108) et un indice optique supplémentaire de valeur supérieure à celle de l'indice optique de l'atmosphère dans laquelle se trouve l'élément à imager et inférieure ou égale à celle de l'indice optique de l'élément à imager.

11. Procédé selon la revendication 10, dans lequel les photo-détecteurs (106) lus au cours de l'étape b) sont ceux se trouvant dans la région (114) de la surface de détection (111) qui est de forme annulaire et délimitée par les rayons (113, 115) de lumière réfléchis formant, contre la surface de capture (109), les premier et deuxième angles limites de réfraction.

12. Procédé selon l'une des revendications 10 ou 11, dans lequel les photo-détecteurs (106) lus au cours de chaque mise en oeuvre de l'étape b) délivrent une image partielle de l'élément à imager telle que chacune des images partielles obtenues se recouvre partiellement avec au moins une autre des images partielles de l'élément à imager.

13. Procédé selon la revendication 12, comportant en outre la mise en oeuvre d'une étape de calcul d'une image finale de l'élément à imager à partir des images partielles de l'élément à imager.

14. Procédé selon l'une des revendications 10 à 13, dans lequel les étapes a) à c) sont également mises en oeuvre pour des sources lumineuses supplémentaires (126) disposées hors de la matrice de sources lumineuses (104) et alignées avec des bissectrices des angles formés par les coins de la matrice de sources lumineuses (104).

**Patentansprüche**

1. Optische Abbildungsvorrichtung (100), die mindestens Folgendes umfasst:

   - ein Array von Lichtquellen (104), die auf einem Substrat (102) hergestellt werden und einen Anzeigebildschirm bilden,
   - ein Array von Fotodetektoren (106), die auf dem Substrat (102) hergestellt und mit dem Array von Lichtquellen (104) verschachtelt sind,
   - ein optisches Medium (108), das die Lichtquellen (104) und die Fotodetektoren (106) abdeckt und durch das sich Licht ausbreiten kann, das dazu bestimmt ist, von den Lichtquellen (104) emittiert zu werden, und eine Erfassungsoberfläche (109), an der ein abzubildendes Element dazu bestimmt ist, angeordnet zu werden, und eine Detektionsoberfläche (111) bildet, die im Wesentlichen parallel zur Erfassungsoberfläche (109) verläuft und an der die Arrays von Lichtquellen (104) und von Fotodetektoren (106) angeordnet sind,
   **dadurch gekennzeichnet, dass** das optische Medium (108) eine Dicke aufweist, die größer ist als der Abstand der Fotodetektoren (106) des Arrays von Fotodetektoren (106),
   und dadurch, dass die optische Abbildungsvorrichtung (100) ferner eine Steuer- und Leseeinrichtung (134, 136, 138, 140) umfasst, die dazu konfiguriert ist, nacheinander jeden Teil der Lichtquellen (104) ein- und auszuschalten und während des Einschaltens jedes Teils der Lichtquellen (104) mindestens einen Teil der Fotodetektoren (106) auszulesen, die dazu bestimmt sind, Lichtstrahlen (113, 115) zu empfangen, die von der eingeschalteten Lichtquelle (104) ausgegeben werden und an der Erfassungsoberfläche (109) reflektiert wurden, indem mit der Erfassungsoberfläche (109) ein Einfallswinkel gebildet wird, der in Abhängigkeit von dem optischen Medium (108) und dem abzubildenden Element geschätzt wird,
   und dadurch, dass jede der Lichtquellen (104) dazu konfiguriert ist, auf der Detektionsoberfläche (111) einen Bereich (114) zu bilden, dessen Größe mindestens doppelt so groß ist wie die Größe einer emittierenden Oberfläche der Lichtquelle,
   und dadurch, dass der Wert des Einfallswinkels zwischen dem eines ersten Grenzbrechungswinkels, der durch den optischen Index des optischen Mediums (108) und den optischen Index der Atmosphäre, in der sich das abzubildende Element befindet, definiert ist, und dem eines zweiten Grenzbrechungswinkels, der durch den optischen Index des optischen Mediums (108) und einen zusätzlichen optischen Index mit einem Wert, der größer ist als der des optischen Index der Atmosphäre, in der sich das abzubildende Element befindet, und kleiner als der oder gleich dem des optischen Index des abzubildenden Elements ist, definiert ist, liegt oder diesem entspricht.

2. Optische Abbildungsvorrichtung (100) nach Anspruch 1, wobei die Steuer- und Leseeinrichtung (134,136,138,140) dazu konfiguriert ist, während des Einschaltens jedes Teils der Lichtquellen (104) die Fotodetektoren (106) auszulesen, die sich im Bereich (114) der Detektionsoberfläche (111) befinden, der ringförmig ist und von den reflektierten Lichtstrahlen (113, 115) begrenzt wird, die an der Erfassungsoberfläche (109) den ersten und den zweiten Grenzbrechungswinkel bilden.

3. Optische Abbildungsvorrichtung (100) nach einem der vorhergehenden Ansprüche, wobei die Steuer- und Leseeinrichtung (134, 136, 138, 140) so konfiguriert sind, dass die beim Einschalten jedes Teils der Lichtquellen (104) ausgelesenen Fotodetektoren (106) ein Teilbild des abzubildenden Elements liefern, so dass sich jedes der erhaltenen Teilbilder mindestens teilweise mit einem anderen Teilbild des abzubildenden Elements überlappt.

4. Optische Abbildungsvorrichtung (100) nach Anspruch 3, die ferner eine Einrichtung zum Berechnen eines endgültigen Bilds des abzubildenden Elements aus Teilbildern des abzubildenden Elements umfasst.

5. Optische Abbildungsvorrichtung (100) nach einem der vorhergehenden Ansprüche, die ferner zusätzliche Lichtquellen (126) umfasst, die außerhalb des Arrays von Lichtquellen (104) angeordnet und auf Halbierende der Winkel ausgerichtet sind, die durch die Ecken des Arrays von Lichtquellen (104) gebildet werden.

6. Optische Abbildungsvorrichtung (100) nach einem der vorhergehenden Ansprüche, wobei jedes Pixel des Anzeigebildschirms eine der Lichtquellen (104) und einen der Fotodetektoren (106) umfasst.

7. Optische Abbildungsvorrichtung (100) nach einem der vorhergehenden Ansprüche, wobei die Lichtquellen (104) durch LEDs gebildet sind und die Steuer- und Leseeinrichtung (134, 136, 138, 140) CMOS-Transistoren umfasst, oder wobei die Lichtquellen (104) vom OLED-Typ sind und die Steuer- und Leseeinrichtung (134, 136, 138, 140) TFT-Transistoren umfasst, die verschachtelt mit dem Array von Fotodetektoren (106) angeordnet sind.

8. Optische Abbildungsvorrichtung (100) nach Anspruch 7, wobei, wenn die Lichtquellen (104) vom OLED-Typ sind und die Steuer- und Leseeinrichtung (134, 136, 138, 140) TFT-Transistoren umfasst, die TFT-Transistoren auf dem Substrat (102) hergestellt sind, das transparent ist und das optische Medium (108) bildet.

9. Optische Abbildungsvorrichtung (100) nach einem der vorhergehenden Ansprüche, wobei die Dicke des optischen Mediums (108) größer ist als 50 $\mu$m, oder wobei das optische Medium (108) eine Glasplatte mit einer Dicke von größer gleich 700 $\mu$m umfasst.

10. Bilderfassungsverfahren, das von einer optischen Abbildungsvorrichtung (100) durchgeführt wird, die mindestens Folgendes umfasst:

   - ein Array von Lichtquellen (104), die auf einem Substrat (102) hergestellt werden und einen Anzeigebildschirm bilden,
   - ein Array von Fotodetektoren (106), die auf dem Substrat (102) hergestellt und mit dem Array von Lichtquellen (104) verschachtelt sind,
   - ein optisches Medium (108), das die Lichtquellen (104) und die Fotodetektoren (106) abdeckt und durch das sich Licht ausbreiten kann, das dazu bestimmt ist, von den Lichtquellen (104) emittiert zu werden, und eine Erfassungsoberfläche (109), an der ein abzubildendes Element dazu bestimmt ist, angeordnet zu werden, und eine Detektionsoberfläche (111) bildet, die im Wesentlichen parallel zur Erfassungsoberfläche (109) verläuft und an der die Arrays von Lichtquellen (104) und von Fotodetektoren (106) angeordnet sind,
   **dadurch gekennzeichnet, dass** das optische Medium (108) eine Dicke aufweist, die größer ist als der Abstand der Fotodetektoren (106) des Arrays von Fotodetektoren (106),
   und dadurch, dass jede der Lichtquellen (104) der optischen Abbildungsvorrichtung (100) dazu konfiguriert ist, auf der Detektionsoberfläche (111) einen Bereich (114) zu bilden, dessen Größe mindestens doppelt so groß ist wie die Größe einer emittierenden Oberfläche der Lichtquelle,
   wobei das Bilderfassungsverfahren das Durchführen der folgenden Schritte durch die Steuer- und Leseeinrichtung (134, 136, 138, 140) der optischen Abbildungsvorrichtung (100) umfasst:

      a) Einschalten einer der Lichtquellen (104),
      b) Auslesen mindestens eines Teils der Fotodetektoren (106), die Lichtstrahlen (113, 115) empfangen, die von der eingeschalteten Lichtquelle (104) ausgegeben werden und an der Erfassungsoberfläche (109) reflektiert wurden, indem mit der Erfassungsoberfläche (109) ein Einfallswinkel gebildet wird, der in Abhängigkeit von dem optischen Medium (108) und dem abzubildenden Element geschätzt wird,
      c) Ausschalten der eingeschalteten Lichtquelle (104),

   wobei die Schritte a) bis c) für jeden Teil der Lichtquellen (104) wiederholt werden, und dadurch, dass der Wert des Einfallswinkels zwischen dem eines ersten Grenzbrechungswinkels, der durch den optischen Index des optischen Mediums (108) und den optischen Index der Atmosphäre, in der sich das abzubildende Element befindet, definiert ist, und dem eines zweiten Grenzbrechungswinkels, der durch den optischen Index des optischen Mediums (108) und einen zusätzlichen optischen Index mit einem Wert, der größer ist als der des optischen Index der Atmosphäre, in der sich das abzubildende Element befindet, und kleiner als der oder gleich dem des optischen Index des abzubildenden Elements ist, definiert ist, liegt oder diesem entspricht.

11. Verfahren nach Anspruch 10, wobei die Fotodetektoren (106), die während des Schritts b) ausgelesen werden, diejenigen sind, die sich im Bereich (114) der Detektionsoberfläche (111) befinden, der ringförmig ist und von den reflektierten Lichtstrahlen (113, 115) begrenzt wird, die an der Erfassungsoberfläche (109) den ersten und den zweiten Grenzbrechungswinkel bilden.

12. Verfahren nach einem der Ansprüche 10 oder 11, wobei die Fotodetektoren (106), die während jedes Durchführens des Schritts b) ausgelesen werden, ein Teilbild des abzubildenden Elements liefern, so dass sich jedes der erhaltenen Teilbilder mindestens teilweise mit einem anderen Teilbild des abzubildenden Elements überlappt.

13. Verfahren nach Anspruch 12, das ferner das Durchführen eines Schritts des Berechnens eines endgültigen Bilds des abzubildenden Elements aus den Teilbildern des abzubildenden Elements umfasst.

**14.** Verfahren nach einem der Ansprüche 10 bis 13, wobei die Schritte a) bis c) ebenfalls für die zusätzlichen Lichtquellen (126) durchgeführt werden, die außerhalb des Arrays von Lichtquellen (104) angeordnet und auf Halbierende der Winkel ausgerichtet sind, die durch die Ecken des Arrays von Lichtquellen (104) gebildet werden.

**Claims**

**1.** Optical imaging device (100) comprising at least:

- an array of light sources (104), produced on a substrate (102) and forming a display screen;
- an array of photo-detectors (106) produced on the substrate (102) and interlaced with the array of light sources (104);
- an optical medium (108), covering the light sources (104) and the photo-detectors (106), through which light intended to be emitted by the light sources (104) is capable of propagating, and forming a capture surface (109) against which an element to image is intended to be arranged and a detection surface (111) substantially parallel to the capture surface (109) and against which the arrays of light sources (104) and photo-detectors (106) are arranged,

**characterized in that** the optical medium (108) has a thickness greater than the pitch of the photo-detectors (106) of the array of photo-detectors (106),

and **in that** the optical imaging device (100) further comprises command and reading means (134, 136, 138, 140) configured for successively lighting and switching off each of a part of the light sources (104) and, during the lighting of each of said part of the light sources (104), reading at least one part of the photo-detectors (106) intended to receive light rays (113, 115) coming from the lit light source (104) and having undergone reflection against the capture surface (109) while forming, with the capture surface (109), an angle of incidence estimated as a function of the optical medium (108) and the element to image,

and **in that** each of the light sources (104) is configured to form, on the detection surface (111), a region (114) the size of which is greater than at least two times the size of an emitting surface of the light source,

and **in that** the value of the angle of incidence is comprised between, or equal to, that of a first limit angle of refraction defined by the optical index of the optical medium (108) and the optical index of the atmosphere in which the element to image is located, and that of a second limit angle of refraction defined by the optical index of the optical medium (108) and an additional optical index of value greater than that of the optical index of the atmosphere in which the element to image is located and less than or equal to that of the optical index of the element to image.

**2.** Optical imaging device (100) according to claim 1, in which the command and reading means (134, 136, 138, 140) are configured to read, during the lighting of each of said part of the light sources (104), the photo-detectors (106) located in the region (114) of the detection surface (111) which is of annular shape and delimited by the reflected light rays (113, 115) forming, against the capture surface (109), the first and second limit refraction angles.

**3.** Optical imaging device (100) according to one of the preceding claims, in which the command and reading means (134, 136, 138, 140) are configured such that the photo-detectors (106) read during the lighting of each of the part of the light sources (104) deliver a partial image of the element to image such that each of the partial images obtained partially overlaps with at least one other of the partial images of the element to image.

**4.** Optical imaging device (100) according to claim 3, further comprising means for computing a final image of the element to image from the partial images of the element to image.

**5.** Optical imaging device (100) according to one of the preceding claims, further comprising additional light sources (126) arranged outside of the array of light sources (104) and aligned with the bisecting lines of the angles formed by the corners of the array of light sources (104).

**6.** Optical imaging device (100) according to one of the preceding claims, in which each pixel of the display screen comprises one of the light sources (104) and one of the photo-detectors (106).

**7.** Optical imaging device (100) according to one of the preceding claims, in which the light sources (104) are formed by LEDs and the command and reading means (134, 136, 138, 140) comprise CMOS transistors, or in which the light sources (104) are of OLED type and the command and reading means (134, 136, 138, 140) comprise TFT transistors arranged in an interlaced manner with the array of photo-detectors (106).

8. Optical imaging device (100) according to claim 7, in which, when the light sources (104) are of OLED type and when the command and reading means (134, 136, 138, 140) comprise TFT transistors, said TFT transistors are produced on the substrate (102) which is transparent and which forms the optical medium (108).

9. Optical imaging device (100) according to one of the preceding claims, in which the thickness of the optical medium (108) is greater than 50 μm, or in which the optical medium (108) comprises a glass plate of thickness greater than or equal to 700 μm.

10. Method for capturing images implemented with an optical imaging device (100) comprising at least:

   - an array of light sources (104), produced on a substrate (102) and forming a display screen;
   - an array of photo-detectors (106) produced on the substrate (102) and interlaced with the array of light sources (104);
   - an optical medium (108), covering the light sources (104) and the photo-detectors (106), through which light intended to be emitted by the light sources (104) is capable of propagating, and forming a capture surface (109) against which an element to image is intended to be arranged and a detection surface (111) substantially parallel to the capture surface (109) and against which the arrays of light sources (104) and photo-detectors (106) are arranged,
   **characterized in that** the optical medium (108) has a thickness greater than the pitch of the photo-detectors (106) of the array of photo-detectors (106),
   and **in that** each of the light sources (104) of the optical imaging device (100) is configured to form, on the detection surface (111), a region (114) the size of which is greater than at least two times the size of an emitting surface of the light source,
   the method for capturing images comprising the implementation, by command and reading means (134, 136, 138, 140) of the optical imaging device (100), of the following steps:

   a) lighting one of the light sources (104);
   b) reading at least one part of the photo-detectors (106) receiving light rays (113, 115) coming from the lit light source (104) and having undergone reflection against the capture surface (109) while forming, with the capture surface (109), an angle of incidence estimated as a function of the optical medium (108) and the element to image;
   c) switching off the lit light source (104);

   steps a) to c) being repeated for each of a part of the light sources (104).
   and **in that** the value of the angle of incidence is comprised between, or equal to, that of a first limit angle of refraction defined by the optical index of the optical medium (108) and the optical index of the atmosphere in which the element to image is located, and that of a second limit angle of refraction defined by the optical index of the optical medium (108) and an additional optical index of value greater than that of the optical index of the atmosphere in which the element to image is located and less than or equal to that of the optical index of the element to image.

11. Method according to claim 10, in which the photo-detectors (106) read during step b) are those located in the region (114) of the detection surface (111) which is of annular shape and delimited by the reflected light rays (113, 115) forming, against the capture surface (109), the first and second limit refraction angles.

12. Method according to one of claims 10 or 11, in which the photo-detectors (106) read during each implementation of step b) deliver a partial image of the element to image such that each of the partial images obtained partially overlap with at least one other of the partial images of the element to image.

13. Method according to claim 12, further comprising the implementation of a step of computing a final image of the element to image from the partial images of the element to image.

14. Method according to one of claims 10 to 13, in which steps a) to c) are also implemented for additional light sources (126) arranged outside of the array of light sources (104) and aligned with the bisecting lines of the angles formed by the corners of the array of light sources (104).

**FIG.1**

**FIG.2**

**FIG.3**

FIG.4

FIG.5

FIG.6

FIG.7

FIG.8

FIG.9

FIG.10

FIG.11

FIG.12

**EP 3 376 544 B1**

## RÉFÉRENCES CITÉES DANS LA DESCRIPTION

**Documents brevets cités dans la description**

- US 20150331508 A1
- US 6259108 B1
- US 2007291325 A1
- US 5627364 A
- US 2002079512 A1
- US 2010155578 A1